# EUROPÄISCHE PATENTANMELDUNG

(11) **EP 2 416 385 A1**
(43) Veröffentlichungstag der Anmeldung: **08.02.2012**
(21) Anmeldenummer: 10171570.4
(22) Anmeldetag: 02.08.2010
(51) Int. Cl.: H01L 31/05, B32B 15/08, B32B 15/20, H05K 3/46

(54) **Mehrlagige Rückkontaktfolie**

(71) Anmelder: Scheuten S.à.r.l., 5916 PA Venlo (NL)
(72) Erfinder: van der Velden, Kees, 6133 VA Sittard (NL); Schuurmans, Frank, 5976 PD Kronenberg (NL)
(74) Vertreter: Jostarndt, Hans-Dieter

(57) **Zusammenfassung**

Die vorliegende Erfindung betrifft eine mehrlagige Rückkontaktfolie, welche mindestens zwei elektrisch leitende Lagen sowie eine dazwischen angeordnete elektrisch nicht leitende Lage umfasst. Zudem betrifft die vorliegende Erfindung auch ein Verfahren zum Verbinden von Solarzellen dank einer erfindungsgemäßen mehrlagigen Rückkontaktfolie.

## Beschreibung

Die vorliegende Erfindung betrifft eine mehrlagige Rückkontaktfolie, welche mindestens zwei elektrisch leitende Lagen sowie eine dazwischen angeordnete elektrisch nicht leitende Lage umfasst. Zudem betrifft die vorliegende Erfindung auch ein Verfahren zum Verbinden von Solarzellen dank einer erfindungsgemäßen mehrlagigen Rückkontaktfolie.

Aus dem Stand der Technik sind dabei sogenannte H-Bar-Solarzellen beziehungsweise H-Bar-Siliziumsolarzellen, bekannt, die durch das Verlöten, insbesondere mit sogenannten Lötbändchen, zum Beispiel aus dünnen Metallstreifen, und einem entsprechenden Lot zu Solarzellketten beziehungsweise zu sogenannten Solarzellstrings, verbunden werden. H-Bar-Solarzellen und insbesondere zum Beispiel H-Bar-Siliziumsolarzellen weisen auf der Vorderseite bevorzugt eine Vorderkontaktanordnung zumeist aus Silber auf, die ein Raster aus dünnen Silberlinien und zwei breitere damit verbundene auf Abstand angeordnete Silberstreifen als Sammelkontakte aufweisen, welche wie ein H ohne Sprosse aussehen. Mehrere Solarzellketten beziehungsweise sogenannte Solarzellstrings können dann anschließend als einzelne Reihen/Zeilen oder Spalten in beziehungsweise zu einem Solarmodul zusammengefügt werden. Dabei kann insbesondere zum Beispiel im Randbereich der Module eine Querverschaltung vorgesehen sein. Eine Querverschaltung kann dabei insbesondere zum Beispiel eine Verschaltung von Solarzellen und/oder Solarzellstrings sein, die bevorzugt quer zum Verlauf der Strings und/oder insbesondere quer zum Verlauf von mindestens zwei Strings erfolgen kann, beziehungsweise die zum Beispiel über mindestens einen Kontakt, Kontaktstreifen und/oder eine Metallbahn erfolgen kann, welcher/welche insbesondere zum Beispiel im Bereich in dem er/sie vorgesehen ist, quer zum Verlauf der Strings und/oder insbesondere quer zum Verlauf von mindestens zwei Strings angeordnet sein kann, und mehrere Solarzellen/Solarzellstrings zum Beispiel parallel und insbesondere in Serie schalten kann.

Dabei müssen die einzelnen H-Bar-Solarzellen zum Verlöten extensiv manipuliert und transportiert werden. Darüber hinaus müssen die gesamten Solarzellstrings, die mehrere miteinander lediglich über die Lötbändchen verbundene Solarzellen umfassen, auch nach ihrer eigentlichen Herstellung zum Zusammenfügen der Solarmodule extensiv manipuliert und transportiert werden.

Bei diesen ganzen Arbeitsschritten können die Solarzellen und/oder die Solarzellstrings beziehungsweise die Verbindungen zwischen einzelnen Solarzellen leicht beschädigt werden, da Solarzellen und insbesondere Siliziumsolarzellen sehr dünne, spröde und empfindliche Siliziumwafer umfassen und die Verbindungen der einzelnen Solarzellen über die dünnen Lötbändchen nur eine äußerst geringe mechanische Stabilität ausweisen. Bei einer Beschädigung der Solarzellen und/oder der Solarzellstrings beziehungsweise einer der Verbindungen zwischen den einzelnen Solarzellen kann bei der Produktion von Solarmodulen erheblicher Ausschuss anfallen.

Um die Anzahl Manipulations- und Transportschritte sowie die Gefahr einer Beschädigung zu reduzieren und gleichzeitig weitere Vorteile zu nutzen, sind aus dem Stand der Technik zum Beispiel auch PUM- (Pin-up module), MWT- (Metal wrap through) oder EWT-Solarzellen (Emitter wrap through) oder andere Typen von Solarzellen bekannt, die sämtliche Kontakte auf der Rückseite aufweisen und keine Kontaktierung der Vorderseite erfordern. Dadurch können einzelne Solarzellen über eine Rückkontaktfolie beziehungsweise eine rückseitige Verbindungsfolie miteinander verbunden werden. Einzelne Solarzellen werden dabei mit ihren Rückkontakten lediglich am richtigen Platz und gegebenenfalls mit der richtigen Ausrichtung auf die Rückkontaktfolie gelegt und eventuell noch mit ihr verbunden, zum Beispiel durch Löten oder durch mindestens einen elektrisch leitenden Kleber, um miteinander elektrisch verbunden und insbesondere zum Beispiel spaltenweise in Serie geschaltet zu werden. Diese Solarzelltypen, die sämtliche Kontakte auf der Rückseite aufweisen, ermöglichen es dabei nicht nur die Anzahl Manipulations- und Transportschritte sowie die Gefahr einer Beschädigung zu reduzieren, sondern insbesondere zum Beispiel auch einen Wirkungsgradvorteil durch weniger Abschattung bei Verzicht auf die Frontkontakte zu erreichen. Des Weiteren können diese Solarzelltypen, die sämtliche Kontakte auf der Rückseite aufweisen, insbesondere zum Beispiel dank des Verzichts auf eine Verbindung durch Lötbändchen näher aneinander platziert werden, um eine dichtere Platzierung zu erreichen und eine bestimmte Fläche besser zu nutzen. Zudem kann durch den Verzicht auf Lötbändchen zum Verbinden der Solarzellen gegebenenfalls zum Beispiel durch eine bessere Optimierung der Verschaltung auch der Verlust bei einer Serienschaltung der Solarzellen reduziert werden.

Die Rückkontaktfolie umfasst dabei eine elektrisch leitende Lage mit einem Muster, die eine Verschaltung der Solarzellen über ihre Rückkontakte ermöglicht. Das Muster weist dabei Plätze für die einzelnen Solarzellen eines geplanten Solarmoduls auf, sodass diese Solarzellen miteinander verbunden und insbesondere zum Beispiel spaltenweise in Serie geschaltet werden können.

Eine Rückkontaktfolie muss dabei ein Muster umfassen, welches so gestaltet ist, dass die Rückkontakte, die den Pluspol der Solarzellen darstellen, durch die Gestaltung des Musters der elektrisch leitenden Lage jeweils miteinander verbunden werden und zudem unerwünschte Verbindungen von Rückkontakten, die den Pluspol der Solarzellen darstellen, und von Rückkontakten, die den Minuspol der Solarzellen darstellen, möglichst verhindert.

Zudem muss die ganze Rückkontaktfolie und insbesondere, dass vorgesehene Muster jeweils an die Position der Kontakte auf der Rückseite der Solarzellen gegebenenfalls in Abhängigkeit des verwendeten Solarzelltyps, an die Anzahl der verwendeten Zellen sowie an die Form und Größe des jeweils gewünschten Solarmoduls angepasst werden.

In der Tat kann die Freiheit bei der Gestaltung des Musters der elektrisch leitenden Lage der Rückkontaktfolie zum Verbinden der Rückkontakte stark einschränkt werden, da alle Rückkontakte der Solarzellen berücksichtigt werden müssen, sodass alle Rückkontakte der Solarzellen mit der Rückkontaktfolie verbunden werden können, und da zudem unerwünschte Kontakte zwischen dem/den Teil(en) des Musters der Rückkontaktfolie, die mit den Rückkontakten, die den Pluspol der Solarzellen darstellen, verbunden ist/sind und dem/den Teil(en) des Musters der Rückkontaktfolie, die mit den Rückkontakten, die den Minuspol der Solarzellen darstellen, verbunden ist/sind möglichst verhindert werden sollen.

Diese Auflagen beschränken dabei die Freiheit der Gestaltung des Musters der elektrisch leitenden Lage der Rückkontaktfolie erheblich und führen sehr schnell zu einer sehr komplexen Gestaltung.

Durch die hohe Komplexität des Musters der elektrisch leitenden Lage werden die Gestaltung und die Herstellung der Rückkontaktfolien extrem aufwendig.

Die Gestaltung beziehungsweise der Verlauf des Musters der elektrisch leitenden Lage der Rückkontaktfolie kann dabei insbesondere bei größeren Modulen beziehungsweise bei einer größeren Anzahl von vorgesehen Solarzellen noch viel komplexer beziehungsweise extrem kompliziert werden. Dies kann insbesondere der Fall sein, wenn mehr als zwei Strings, die gegebenenfalls jeweils über eine Bypass-Diode umgangen werden können, vorgesehen sind und/oder wenn auf eine Querverschaltung der Solarzellen verzichtet werden soll, da dadurch noch zusätzliche Auflagen durch die Gestaltung beziehungsweise das Muster der elektrisch leitenden Lage der Rückkontaktfolie erfüllt werden müssen.

Im Falle eines Verzichts auf eine Querverschaltung muss die Rückkontaktfolie ein Muster umfassen, welches gegebenenfalls alleine durch eine geeignete Gestaltung eine Verschaltung der Solarzellen über ihre Rückkontakte ermöglicht. Das Muster weist dabei Plätze für die einzelnen Solarzellen eines geplanten Solarmoduls auf, sodass diese Solarzellen gegebenenfalls alleine durch eine geeignete Gestaltung des Musters miteinander verbunden und insbesondere zum Beispiel spaltenweise in Serie geschaltet werden können.

Bei mehreren und insbesondere mehr als zwei Solarzellstrings, die gegebenenfalls jeweils über eine Bypass-Diode umgangen werden können, muss die Rückkontaktfolie zudem ein Muster umfassen, welches gegebenenfalls alleine durch eine geeignete Gestaltung eine Verschaltung der einzelnen Solarzellstrings mit den jeweiligen Bypass-Dioden ermöglicht.

Diese Auflagen beschränken dabei die Freiheit der Gestaltung des Musters der elektrisch leitenden Lage der Rückkontaktfolie weiter und führen zu einer noch komplexeren Gestaltung.

Angesichts des Stands der Technik besteht daher der Bedarf an einer Möglichkeit, die Komplexität des Musters der elektrisch leitenden Schicht zu reduzieren.

Es ist daher die Aufgabe der vorliegenden Erfindung, eine Möglichkeit dazu zur Verfügung zu stellen.

Dies wird durch eine mehrlagige Rückkontaktfolie nach Anspruch 1 sowie durch ein Verfahren zum Verbinden von Solarzellen mit den Merkmalen des Anspruchs 10 erreicht.

Weitere vorteilhafte Ausführungsformen des erfindungsgemäßen Verfahrens ergeben sich aus der Beschreibung, den Unteransprüchen und den Zeichnungen.

Die vorliegende Erfindung betrifft eine mehrlagige Rückkontaktfolie, welche mindestens zwei elektrisch leitende Lagen sowie eine dazwischen angeordnete elektrisch nicht leitende Lage umfasst.

Mindestens zwei elektrisch leitende Lagen können es dabei ermöglichen, jeweils die Rückkontakte, die den Minuspol einer/jeder Solarzelle darstellen, mit einer elektrisch leitenden Lage der mehrlagigen Rückkontaktfolie und die Rückkontakte, die den Pluspol einer/jeder Solarzelle darstellen, mit einer weiteren beziehungsweise anderen elektrisch leitenden Lage zu verbinden. Die Rückkontakte der Solarzellen können dabei jede beliebige Gestaltung aufweisen. Insbesondere können die Rückkontakte zum Beispiel Kontaktpunkte und/oder Kontaktstreifen und/oder Kontaktflächen umfassen.

Im Gegensatz dazu muss eine aus dem Stand der Technik bekannte Rückkontaktfolie mit einer einzigen elektrisch leitenden Lage ein Muster umfassen, welches so gestaltet ist, dass die Rückkontakte, die den Pluspol der Solarzellen darstellen, durch die Gestaltung des Musters der elektrisch leitenden Lage jeweils miteinander verbunden werden, ohne dass es zu unerwünschten Verbindungen von Rückkontakten, die den Pluspol der Solarzellen darstellen, und von Rückkontakten, die den Minuspol der Solarzellen darstellen, kommt. Zudem kommen zusätzliche Auflagen dazu, da alle Rückkontakte der Solarzellen berücksichtigt werden müssen beziehungsweise da durch das Muster der alleinigen elektrisch leitenden Lage alle Rückkontakte der Solarzellen kontaktiert werden müssen.

Darüber hinaus können noch zusätzliche Auflagen durch einen Verzicht auf eine Querverschaltung und/oder bei mehreren und insbesondere bei mehr als zwei vorgesehenen Solarzellstrings, die gegebenenfalls jeweils über eine Bypass-Diode umgangen werden können, hinzu kommen. Dass ein Solarzellstring und/oder mindestens ein Teil eines Solarzellstrings gegebenenfalls umgangen werden kann, kann dabei bedeuten, dass dieser Solarzellstring aus dem Stromkreis eines Solarmoduls und/oder aus dem mit mindestens einem Anschlusspunkt verbundenen Stromkreis insbesondere zum Beispiel über eine Bypass-Diode ausgenommen wird beziehungsweise dass der Strom innerhalb des Stromkreises des Solarmoduls und/oder innerhalb des mit mindestens einem Anschlusspunkt verbundenen Stromkreises zum Beispiel über eine Bypass-Diode so geleitet wird, dass bevorzugt kein Stromfluss durch diesen Solarzellstring oder diesen ein Teil eines Solarzellstrings erfolgt beziehungsweise benötigt wird.

Die vorgenannten Auflagen beschränken dabei die Freiheit der Gestaltung des Musters der elektrisch leitenden Lage der Rückkontaktfolie erheblich und führen sehr schnell zu einer sehr komplexen Gestaltung. Die Gestaltung einer elektrisch leitenden Lage beziehungsweise die Gestaltung eines Musters einer elektrisch leitenden Lage kann dabei insbesondere zum Beispiel das Design der Form darstellen. Ein Muster beziehungsweise das Muster einer elektrisch leitenden Lage kann dabei gegebenenfalls insbesondere zum Beispiel die Form einer elektrischen Lage darstellen.

Durch mindestens zwei elektrisch leitende Lagen kann im Gegensatz dazu eine viel größere Flexibilität bezüglich der Gestaltung der Muster der elektrisch leitenden Lagen ermöglicht werden.

Die mindestens zwei elektrisch leitenden Lagen sind dabei räumlich getrennt und insbesondere nicht in der gleichen Ebene angeordnet. Dadurch kann die Gestaltung einer/jeder Lage viel freier gewählt werden. Die Gestaltung des Musters für eine elektrisch leitende Lage kann die Gestaltung einer weiteren elektrisch leitenden Lage bevorzugt zum Beispiel nur sehr wenig bis gar nicht beschränken, da beide elektrisch leitenden Lagen in unterschiedlichen Ebenen angeordnet sind.

Bei einer erfindungsgemäßen mehrlagigen Rückkontaktfolie schränkt die Gestaltung einer elektrisch leitenden Lage, um die Rückkontakte, die den Pluspol einer/jeder Solarzelle darstellen, durch die elektrisch leitende Lage jeweils miteinander und gegebenenfalls auch mit den Rückkontakten, die einen Minuspol mindestens einer weiteren anderen Solarzelle darstellen, zu verbinden, die Freiheit bei der Gestaltung einer weiteren elektrisch leitenden Lage zum Verbinden der Rückkontakte der/jeder Solarzelle, die den Minuspol der Solarzellen darstellen, miteinander und gegebenenfalls auch mit den Rückkontakten, die einen Pluspol mindestens einer/jeder weiteren Solarzelle darstellen, nicht wesentlich ein, da die beiden elektrisch leitenden Lagen in unterschiedlichen Ebenen angeordnet sind.

Jede elektrisch leitende Lage kann dabei zum Beispiel zum Kontaktieren der Solarzellen verwendet werden. Bevorzugterweise kann jede elektrisch leitende Lage dabei zum Beispiel zumindest mit einem Teil der Rückkontakte mindestens einer beziehungsweise jeder Solarzelle verbunden beziehungsweise unmittelbar elektrisch verbunden werden.

In einer Ausführungsform einer erfindungsgemäßen mehrlagigen Rückkontaktfolie kann mindestens eine elektrisch leitende Lage jedoch gegebenenfalls teilweise beziehungsweise lokal für andere Zwecke, wie zum Beispiel um die elektrische Verbindung zwischen einem Teil/Punkt und einem anderen Teil/Punkt einer mehrlagigen Rückkontaktfolie beziehungsweise des Musters mindestens einer elektrisch leitenden Lage einer der mehrlagigen Rückkontaktfolie herzustellen, genutzt werden. Dadurch können gegebenenfalls einfacher/bequemer beziehungsweise gegebenenfalls mit einer relativ einfachen Gestaltung der elektrisch leitenden Lage mehr Solarzellstrings und insbesondere mehr als 3 Solarzellstrings, die jeweils über eine Bypass-Diode umgangen werden können, bei gleichzeitigem Verzicht auf eine Querverschlatung vorgesehen werden.

Durch eine erfindungsgemäße mehrlagige Rückkontaktfolie lässt sich die Gestaltung einer/jeder elektrisch leitenden Lage demnach erheblich vereinfachen. Gegebenenfalls kann/können mindestens eine beziehungsweise mindestens zwei elektrisch leitende Lage(n) dadurch zum Beispiel lediglich zum Beispiel durch Trennbereiche beziehungsweise Trennlinien getrennte durchgehende elektrisch leitende Flächen umfassen, welche gegebenenfalls zum Beispiel abgesehen von optionalen Durchbrüchen und/oder optionale Aussparungen (insbesondere zum Beispiel ringförmige Aussparungen) kein besonders Muster aufweisen können. Eine durchgehende elektrisch leitende Fläche kann demnach gegebenenfalls lediglich optionale Durchbrüche und/oder optionale Aussparungen aufweisen. Jede durchgehende elektrisch leitende Fläche einer elektrisch leitenden Lage kann dabei von mindestens einer und insbesondere von allen weiteren durchgehenden elektrisch leitenden Flächen dieser elektrisch leitenden Lage durch mindestens einen oder mehrere Trennbereiche getrennt und somit gegebenenfalls elektrisch isoliert sein. Ein Trennbereich kann dabei zum Beispiel bevorzugt ein elektrisch nicht leitender Bereich des Musters einer elektrisch leitenden Lage sein, der frei von elektrisch leitendem Material ist und mindestens zwei elektrisch leitende Bereiche beziehungsweise mindestens zwei durchgehende elektrisch leitende Flächen der elektrischen leitenden Lage trennt und gegebenenfalls voneinander elektrisch isoliert. Ein Trennbereich kann dabei zum Beispiel zumindest teilweise eine unter einer elektrisch leitenden Lage angeordnete elektrisch nicht leitende Lage freilegen. Ein Trennbereich kann dabei jede beliebige Form aufweisen und/oder insbesondere auch eine Trennlinie sein. Eine durchgehende elektrisch leitende Fläche kann gegebenenfalls jede beliebige Form und insbesondere zum Beispiel eine runde und/oder eine annähernd runde, quadratische und/oder eine annähernd quadratische, rechteckige und/oder annähernd rechteckige oder knochenförmige Form aufweisen. Bevorzugt kann eine durchgehende elektrisch leitende Fläche eine Form aufweisen, deren Kontur es ermöglich alle Rückkontakte, die den Pluspol oder den Minuspol mindestens einer Solarzelle darstellen, gegebenenfalls über die durchgehende elektrisch leitende Fläche miteinander und/oder mit dieser durchgehenden elektrisch leitenden Fläche zu verbinden. Alternativ kann eine durchgehende elektrisch leitende Fläche eine Form aufweisen, deren Kontur es ermöglich alle Rückkontakte, die den Pluspol einer Solarzelle darstellen, und alle Rückkontakte, die den Minuspol einer weiteren bevorzugt benachbarten Solarzellen darstellen, gegebenenfalls mit dieser durchgehenden elektrisch leitenden Fläche zu verbinden. Die durchgehenden elektrisch leitenden Flächen mindestens einer beziehungsweise mindestens zweier elektrisch leitenden Lage(n), welche gegebenenfalls lediglich zum Beispiel durch Trennbereiche beziehungsweise Trennlinien jeweils voneinander und von den übrigen durchgehenden elektrisch leitenden Flächen getrennt sind und zudem gegebenenfalls zum Beispiel abgesehen von optionalen Durchbrüchen, kein besonderes Muster aufweisen, können jede beliebige Form und insbesondere zum Beispiel eine runde und/oder eine annähernd runde, quadratische und/oder eine annähernd quadratische, rechteckige und/oder annähernd rechteckige oder knochenförmige Form aufweisen. Die/jede durchgehende(n) elektrisch leitende(n) Fläche(n) mindestens einer beziehungsweise mindestens zweier elektrisch leitenden Lage(n) kann/können sich bevorzugt zum Beispiel jeweils zumindest teilweise über die von mehreren Solarzellen und insbesondere über die von zwei Solarzellen beziehungsweise bevorzugt von zwei benachbarten Solarzellen bedeckte Fläche erstrecken. Die durchgehenden elektrisch leitenden Flächen mindestens einer beziehungsweise mindestens zweier elektrisch leitenden Lage(n) können sich dabei bevorzugt zum Beispiel zumindest teilweise über die von mehreren Solarzellen und insbesondere über die von zwei Solarzellen beziehungsweise zwei benachbarten Solarzellen bedeckte Fläche erstrecken, um die Rückkontakte, die den Pluspol einer/jeder Solarzelle darstellen, durch die mindestens zwei elektrisch leitenden Lagen jeweils miteinander und auch mit den Rückkontakten, die einen Minuspol mindestens einer weiteren bevorzugt zum Beispiel benachbarten Solarzelle darstellen, zu verbinden und die/beide Solarzellen, die über jeder elektrisch leitenden Fläche einer elektrisch leitenden Lage angeordnet sein können, über mindestens zwei elektrisch leitende Lagen somit gegebenenfalls zum Beispiel in Serie zu schalten. Benachbarte Solarzellen können dabei zum Beispiel Solarzellen sein, die aneinander angrenzen, sodass keine weitere Solarzelle zwischen ihnen vorgesehen ist. Darüber hinaus können die durchgehenden elektrisch leitenden Flächen von mindestens zwei elektrisch leitenden Lagen und/oder insbesondere die durchgehenden elektrisch leitenden Flächen, die sich über die von mindestens zwei Solarzellen bedeckte Fläche erstrecken und die zu mindestens zwei elektrisch leitenden Lagen gehören, bevorzugt zum Beispiel so angeordnet sein, dass jede/eine durchgehende elektrisch leitende Fläche mindestens einer/jeder elektrisch leitenden Lage sich jeweils zumindest teilweise unter und/oder über mindestens zwei durchgehende elektrisch leitende Flächen mindestens einer weiteren elektrisch leitenden Lage erstreckt. Eine/zwei durchgehende elektrisch leitende Fläche, die zu einer beziehungsweise mindestens zwei elektrisch leitende(n) Lage(n) gehört, kann zum Beispiel eine durchgehende elektrisch leitende Fläche einer beziehungsweise respektive von mindestens zwei elektrisch leitende(n) Lage(n) darstellen. Dadurch können Solarzellen und insbesondere benachbarte Solarzellen mit einer erfindungsgemäßen mehrlagigen Rückkontaktfolie besonders bequem jeweils in Serie geschaltet werden. Bevorzugt können dabei zum Beispiel alle Solarzellen, die mit einer mehrlagigen Rückkontaktfolie verbunden werden, in Serie geschaltet werden. In einer Ausführungsform können bevorzugt alle durchgehenden elektrisch leitenden Flächen von mindestens zwei elektrisch leitenden Lagen, bis auf mindestens eine bevorzugt zwei und/oder drei und/oder vier durchgehende elektrisch leitende Flächen einer und bevorzugt zum Beispiel der unteren/untersten elektrisch leitenden Lage zum Beispiel so angeordnet sein, dass jede/die durchgehende(n) elektrisch leitende(n) Fläche(n) mindestens einer elektrisch leitenden Lage sich jeweils zumindest teilweise unter und/oder über mindestens zwei durchgehenden elektrisch leitenden Flächen mindestens einer weiteren elektrisch leitenden Lage erstreckt/erstrecken. In einer weiteren Ausführungsform können bevorzugt alle durchgehenden elektrisch leitenden Flächen, die sich zumindest teilweise über die von zwei Solarzellen bedeckte Fläche erstrecken, zum Beispiel so angeordnet sein, dass jede/die durchgehende(n) elektrisch leitende(n) Fläche(n) mindestens einer elektrisch leitenden Lage sich jeweils zumindest teilweise unter und/oder über mindestens zwei durchgehenden elektrisch leitenden Flächen mindestens einer weiteren elektrisch leitenden Lage erstreckt/erstrecken. Dadurch können Solarzellen und insbesondere benachbarte Solarzellen mit einer erfindungsgemäßen mehrlagigen Rückkontaktfolie besonders bequem jeweils in Serie geschaltet werden. Eine elektrisch leitende Lage und insbesondere zum Beispiel die untere/unterste elektrisch leitende Lage kann dabei jedoch auch mindestens eine bevorzugt jedoch mehrere und insbesondere mindestens zwei durchgehende elektrisch leitende Flächen umfassen, die sich nicht jeweils zumindest teilweise unter und/oder über mindestens zwei durchgehenden elektrisch leitenden Flächen mindestens einer weiteren elektrisch leitenden Lage erstreckt/erstrecken, wobei diese durchgehenden elektrisch leitenden Flächen insbesondere zum Beispiel quadratische und/oder annähernd quadratisch beziehungsweise runde und/oder annähernd runde durchgehende elektrisch leitende Flächen sein können, welche ungefähr der Größe/dem Durchmesser einer verwendeten Solarzelle entsprechen können. Mindestens eine bevorzugt jedoch mehrere und insbesondere mindestens zwei durchgehende elektrisch leitende Fläche(n) einer elektrisch leitenden Lage und insbesondere zum Beispiel der unteren/untersten elektrisch leitenden Lage, die sich nicht jeweils zumindest teilweise unter und/oder über mindestens zwei durchgehende elektrisch leitende Flächen mindestens einer weiteren elektrisch leitenden Lage erstreckt/erstrecken, können dabei gegebenenfalls zum Beispiel jeweils den Pluspol und den Minuspol eines Solarmoduls darstellen und/oder an mindestens einem Anschlusspunkt angrenzen und/oder zumindest teilweise darüber liegen und/oder jeweils mit mindestens einem an mindestens einem Anschlusspunkt vorgesehenen Kontakt und/oder mit der/einer am Anschlusspunkt vorgesehenen Anschlussbuchse elektrisch verbunden werden. Ein Anschlusspunkt kann dabei zum Beispiel ein Punkt sein an dem der über die Rückkontakte der Solarzellen abgeleitete Strom zusammen kommt beziehungsweise abgeführt wird und/oder an dem mindestens zwei Kontakte jeder Gruppe von mindestens zwei Solarzellen, die über mindestens zwei elektrisch leitende Lagen in Serie geschaltet sind, welche bevorzugt zum Beispiel jeweils den Pluspol und den Minuspol jeder Gruppe von mindestens zwei Solarzellen darstellen, die über mindestens zwei elektrisch leitende Lagen in Serie geschaltet sind, zusammen kommen beziehungsweise geführt werden und/oder an dem der Pluspol und/oder der Minuspol mindestens einer Gruppe von mindestens zwei Solarzellen, die über mindestens zwei elektrisch leitende Lagen in Serie geschaltet sind geführt wird/werden und/oder an dem mindestens eine elektrische Verbindung hergestellt werden kann, um den durch ein Solarmodul hergestellten Strom gegebenenfalls von dem Solarmodul aus abzuführen. Dass mindestens ein Kontakt und oder dass mindestens der Pluspol und/oder der Minuspol mindestens einer Gruppe von mindestens zwei Solarzellen, die über mindestens zwei elektrisch leitende Lagen in Serie geschaltet sind, an mindestens einen Punkt und insbesondere mindestens einen Anschlusspunkt geführt wird/werden kann dabei zum Beispiel bedeuten, dass die mehrlagige Rückkontaktfolie und insbesondere deren Lagen bevorzugt gegebenenfalls so gestaltet sind, dass der Pluspol und/oder der Minuspol mindestens einer Gruppe von mindestens zwei Solarzellen, die über mindestens zwei elektrisch leitende Lagen in Serie geschaltet sind, an einer an mindestens einem Punkt und insbesondere an mindestens einem Anschlusspunkt angrenzenden durchgehenden elektrisch leitenden Fläche der unteren/untersten elektrisch leitenden Lage und/oder zumindest teilweise über einer an mindestens einem Anschlusspunkt vorgesehenen Anschlussbuchse liegt und/oder gebracht wird.

Dadurch lässt sich die Gestaltung einer/jeder elektrisch leitenden Lage erheblich vereinfachen, insbesondere auch wenn auf eine Querverschaltung verzichtet wird und/oder wenn mehr als zwei Solarzellstrings, die gegebenenfalls jeweils über eine Bypass-Diode umgangen werden können, innerhalb eines herzustellenden Moduls vorgesehen sind.

Zudem können durch mindestens eine elektrisch nicht leitende Lage, die zwischen mindestens zwei elektrisch leitende Lagen angeordnet ist, gegebenenfalls zum Beispiel Kurzschlüsse und/oder andere Fehlfunktionen insbesondere zum Beispiel durch unbeabsichtigte Kontakte zwischen zwei elektrisch leitenden Lagen der mehrlagigen Rückkontaktfolie, sehr bequem weitestgehend verhindert werden.

Eine elektrisch leitende Lage kann dabei zum Beispiel eine Leitfähigkeit von 0,05 S/m bis 1×10¹⁰ S/m, bevorzugt eine elektrische Leitfähigkeit von 1 S/m bis 1×10⁹ S/m weiter bevorzugt eine elektrische Leitfähigkeit von 1×10⁴ S/m bis 1×10⁸ S/m, weiter bevorzugt eine elektrische Leitfähigkeit von 1×10⁶ S/m bis 1×10⁷ S/m, weiter bevorzugt eine elektrische Leitfähigkeit von 9×10⁶ S/m bis 63×10⁶ S/m, besonders bevorzugt eine elektrische Leitfähigkeit von 37×10⁶ S/m bis 58×10⁶ S/m, aufweisen. Zudem kann eine elektrisch leitende Lage dabei zum Beispiel eine Dicke von 1 µm bis 0,5 cm, bevorzugt 2 µm bis 1 mm, weiter bevorzugt 3 µm bis 300 µm, weiter bevorzugt 5 µm bis 50 µm, weiter bevorzugt 10 µm bis 30 µm, besonders bevorzugt 15 µm bis 25 µm, aufweisen.

Eine elektrisch nicht leitende Lage kann dabei zum Beispiel eine elektrische Leitfähigkeit von weniger als 0,05 S/m, bevorzugt von weniger als 0,005 S/m, weiter bevorzugt von weniger als 1×10⁻⁴ S/m, weiter bevorzugt von weniger als 1×10⁻⁵ S/m, besonders bevorzugt von weniger als 1×10⁻⁶ S/m, aufweisen.

Dabei kann eine elektrisch nicht leitende Lage dabei zum Beispiel eine Dicke von 1 µm bis 0,5 cm, bevorzugt 2 µm bis 1 mm, weiter bevorzugt 5 µm bis 500 µm, weiter bevorzugt 10 µm bis 250 µm, weiter bevorzugt 15 µm bis 150 µm, weiter bevorzugt 20 µm bis 130 µm, weiter bevorzugt 25 µm bis 125 µm, besonders bevorzugt 30 µm bis 75 µm, aufweisen.

In einer Ausführungsform der mehrlagigen Rückkontaktfolie können mehrere und insbesondere zum Beispiel zwei Anschlusspunkte vorgesehen sein. Alternativ kann jedoch auch ein einziger Anschlusspunkt vorgesehen sein. Der Anschlusspunkt kann dabei mindestens einen gegebenenfalls jedoch auch mehrere positive(n) und mindestens einen gegebenenfalls jedoch auch mehrere negative(n) Kontakt(e) aufweisen, die zum Beispiel eine elektrische Verbindung zwischen einer Anschlussbuchse und den am Anschlusspunkt angrenzenden und/oder teilweise darüber liegenden durchgehenden elektrisch leitenden Flächen eine elektrisch leitenden Lage und insbesondere zum Beispiel der unteren/untersten elektrisch leitenden Lage ermöglichen können.

Insbesondere kann eine mehrlagige Rückkontaktfolie zum Beispiel alle Rückkontakte über mindestens zwei elektrisch leitende Lagen miteinander und über eine der elektrisch leitenden Lagen und insbesondere über die untere/unterste elektrisch leitende Lage mit einem Anschlusspunkt verbinden, wobei die Rückkontakte über mindestens zwei elektrisch leitende Lagen so miteinander verbunden werden, dass die Rückkontakte, die den Pluspol mindestens einer/jeder Solarzelle darstellen, jeweils mit den Rückkontakten, die den Minuspol einer weiteren bevorzugt zum Beispiel benachbarten Solarzelle darstellen, verbunden werden können. Demnach können alle mit einer Rückkontaktfolie verbundenen Solarzellen bevorzugt über mindestens zwei elektrisch leitende Lagen zum Beispiel in Serie geschaltet und über eine elektrisch leitende Lage, bevorzugt zum Beispiel die untere/unterste elektrisch leitende Lage gegebenenfalls zum Beispiel mit einem daran angebrachten Anschlusspunkt beziehungsweie einer daran angebrachten Anschlussbuchse verbunden werden.

Mindestens zwei Solarzellen in Serie schalten beziehungsweise der Ausdruck "mindestens zwei in Serie geschaltete Solarzellen" kann dabei zum Beispiel mindestens zwei Solarzellen in Reihe schalten beziehungsweise "mindestens zwei in Reihe geschaltete Solarzellen" bedeuten beziehungsweise bedeuten, dass mindestens zwei Solarzellen so miteinander verbunden und/oder verschaltet sein können, dass der Pluspol mindestens einer/jeder Solarzelle jeweils mit dem Minuspol einer weiteren Solarzelle und/oder der Minuspol einer/jeder Solarzelle mit dem Pluspol einer weiteren Solarzelle verbunden und/oder verschaltet sein kann.

Darüber hinaus kann eine mehrlagige Rückkontaktfolie zum Beispiel mindestens eine und bevorzugt mindestens zwei, weiter bevorzugt mindestens 3, weiter bevorzugt mindestens 4, weiter bevorzugt mindestens 5, weiter bevorzugt mindestens 6 Solarzellstrings beziehungsweise Gruppe(n) von mindestens zwei Solarzellen über mindestens zwei elektrisch leitende Lagen gegebenenfalls in Serie schalten und mit einem Anschlusspunkt verbinden. Eine Gruppe von mindestens zwei Solarzellen, die in Serie geschaltet sind, beziehungsweise ein Solarzellstring kann dabei insbesondere zum Beispiel eine Gruppe von mindestens zwei Solarzellen sein, die in Serie geschaltet beziehungsweise bevorzugt über mindestens zwei elektrisch leitende Lagen in Serie geschaltet sein können, und die zudem gegebenenfalls jeweils über mindestens eine Bypass-Diode und insbesondere über mindestens einer bevorzugt zum Beispiel in der Anschlussbuchse vorgesehene Bypass-Diode und/oder über die am Anschlusspunkt vorgesehenen Kontakte im Stromkreis umgangen werden können, wobei der Pluspol und der Minuspol einer Gruppe von mindestens zwei Solarzellen, die in Serie geschaltet sind, beziehungsweise eines Solarzellstrings jeweils zu mindestens einem Anschlusspunkt geführt werden können und/oder beide zu einem einzigen Anschlusspunkt geführt werden können und/oder jeweils an mindestens einen Anschlusspunkt angrenzen können und/oder beide an einen einzigen Anschlusspunkt angrenzen können. Dass eine Gruppe von mindestens zwei Solarzellen, die in Serie geschaltet sind, beziehungsweise dass ein Solarzellstring im Stromkreis umgangen werden kann, kann dabei bedeuten, dass bevozugt alle Solarzellen des Solarzellstrings beziehungsweise der Gruppe von mindestens zwei in Serie geschalteten Solarzellen und/oder gegebenenfalls zumindest ein Teil der Solarzellen des Solarzellstrings beziehungsweise der Gruppe von mindestens zwei in Serie geschalteten Solarzellen umgangen werden kann/können. Dass zumindest ein Teil der Solarzellen des Solarzellstrings beziehungsweise der Gruppe von mindestens zwei in Serie geschalteten Solarzellen umgangen werden kann, kann dabei zum Beispiel gegebenenfalls bedeuten, dass alle Solarzellen des Solarzellstrings beziehungsweise der Gruppe von mindestens zwei in Serie geschalteten Solarzellen bis auf eine oder zwei im Stromkreis umgangen werden können. Ein Teil eines Solarzellstrings kann demnach bevorzugt zum Beispiel alle gegebenenfalls zum Beispiel in Serie geschalteten Solarzellen eines Solarzellstrings bis auf eine oder zwei umfassen.

Ein Solarzellstring beziehungsweise eine Gruppe von mindestens zwei Solarzellen, die über mindestens zwei elektrisch leitende Lagen in Serie geschaltet sind, kann einen Pluspol und einen Minuspol aufweisen. Der Pluspol und/oder der Minuspol eines Solarzellstrings beziehungsweise einer Gruppe von mindestens zwei Solarzellen, die über mindestens zwei elektrisch leitende Lagen in Serie geschaltet sind, können dabei jeweils mehrere Kontakte und/oder insbesondere mehrere Rückkontakte umfassen. Der Pluspol eines Solarzellstrings kann dabei zum Beispiel insbesondere die Rückkontakte, welche den Pluspol einer ersten und/oder letzten in Serie geschalteten Solarzelle einer Gruppe von mindestens zwei in Serie geschalteten Solarzellen darstellen, umfassen. Der Minuspol eines Solarzellstrings kann dabei insbesondere zum Beispiel die Rückkontakte, welche den Minuspol einer ersten und/oder letzten in Serie geschalteten Solarzelle einer Gruppe von mindestens zwei in Serie geschalteten Solarzellen darstellen, umfassen. Der Pluspol oder der Minuspol eines Solarzellstrings kann insbesondere zum Beispiel ein beziehungsweise mehrere Kontakt(e) insbesondere mehrere Rückkontakte sein, die mit dem Anschlusspunkt und/oder der Anschlussbuchse beziehungsweise mit einer am Anschlusspunkt und/oder bevorzugt in der Anschlussbuchse vorgesehenen Bypass-Diode und/oder mit mindestens einer Fläche, welche an den Anschluss angrenzt und/oder zumindest teilweise über dem Anschlusspunkt und/oder der Anschlussbuchse angeordnet ist und/oder mit mindestens einer durchgehenden elektrisch leitenden Fläche einer elektrisch leitenden Lage beziehungsweise der unteren/untersten elektrisch leitenden Lage, die mit mindestens einem am Anschlusspunkt vorgesehenen Kontakt einer Anschlussbüchse verbunden ist, verbunden ist/sind. Der Pluspol und/oder der Minuspol eines/jedes Solarzellstrings kann demnach jeweils an den Anschlusspunkt geführt werden. Ein Anschlusspunkt kann demnach zum Beispiel ein Punkt sein an dem der über die Rückkontakte der Solarzellen abgeleitete Strom zusammen kommt beziehungsweise gegührt wird und/oder an dem mindestens ein bevorzugt jedoch mindestens zwei Kontakt(e) jeder Gruppe von mindestens zwei Solarzellen, die über mindestens zwei elektrisch leitende Lagen in Serie geschaltet sind, welcher/welche bevorzugt zum Beispiel jeweils den Pluspol und/oder den Minuspol jeder Gruppe von mindestens zwei Solarzellen darstellt/darstellen, die über mindestens zwei elektrisch leitende Lagen in Serie geschaltet sind, zusammen kommen beziehungsweise geführt wird/werden. Dabei kann die erste Solarzelle eines Solarzellstrings gebenenfalls zum Beispiel auch die letzte Solarzelle eines anderen Solarzellstrings darstellen. Genauso kann gegebenenfalls die letzte Solarzelle eines Solarzellstrings zum Beispiel die erste Solarzelle eines anderen Solarzellstrings darstellen. Am Anschlusspunkt kann zudem mindestens eine und bevorzugt genau eine Anschlussbuchse vorgesehen sein, um den durch die mit der Rückkontaktfolie verbundenen Solarzellen produzierten Strom abzuführen und/oder gegebenenfalls mehrere Solarmodule miteinander zu verbinden. Eine am Anschlusspunkt vorgesehene Anschlussbuchse kann dabei für jede Gruppe von mindestens zwei Solarzellen, die über mindestens zwei elektrisch leitende Lagen in Serie geschaltet sind, zum Beispiel jeweils eine Bypass-Diode umfassen. Eine Bypass-Diode kann es dabei erlauben mindestens eine/jede Gruppe von mindestens zwei Solarzellen, die über mindestens zwei elektrisch leitende Lagen in Serie geschaltet sind, zum Beispiel gegebenenfalls zu umgehen. Dies kann insbesondere zum Beispiel wünschenswert sein, wenn zum Beispiel eine Gruppe von mindestens zwei Solarzellen, die über mindestens zwei elektrisch leitende Lagen in Serie geschaltet zum Beispiel wegen einer Abschattung also eines darüber liegenden Schattens und/oder wegen eines Fehlers beziehungsweise Stromkreisunterbrechung weniger als geplant und/oder keinen Strom produziert. Durch das Umgehen mindestens eines Solarzellstrings können gegebenenfalls Spannungs- und/oder Stromstärke- und/oder Leistungsparameter von hergestellten Modulen dank einer erfindungsgemäßen mehrlagigen Rückkontaktfolie insbesondere bei einer Abschattung eines Teils eines Moduls und/oder bei einem Fehler beziehungsweise einer Stromkreisunterbrechung insbesondere zum Beispiel in einem Solarzellstring optimiert werden. Zudem kann dadurch gegebenenfalls auch ein totaler Ausfall des Moduls und/oder die Bildung von Hotspots insbesondere bei einer Abschattung eines Teils eines Moduls und/oder bei einem Fehler beziehungsweise einer Stromkreisunterbrechung verhindert werden.

Mindestens ein Kontakt, welcher den Pluspol einer/ jeder Gruppe von mindestens zwei über mindestens zwei elektrisch leitende Lagen in Serie geschalteten

Solarzellen darstellen kann, und mindestens ein Kontakt, welcher den Minuspol einer/ jeder Gruppe von mindestens zwei über mindestens zwei elektrisch leitende Lagen in Serie geschalteten Solarzellen darstellen kann, können demnach an einem Punkt und/oder an einem Anschlusspunkt beziehungsweise an jeweils einer am Anschlusspunkt vorgesehenen durchgehenden elektrisch leitenden Fläche des Musters einer elektrisch leitenden Lage und insbesondere der unteren/untersten elektrisch leitenden Lage geführt werden. Mindestens ein Kontakt, welcher den Pluspol einer/ jeder Gruppe von mindestens zwei über mindestens zwei elektrisch leitende Lagen in Serie geschalteten Solarzellen darstellen kann, und mindestens ein Kontakt, welcher den Minuspol einer/ jeder Gruppe von mindestens zwei über mindestens zwei elektrisch leitende Lagen in Serie geschalteten Solarzellen darstellen kann, können dabei an unterschiedlichen am Anschlusspunkt vorgesehenen durchgehenden elektrisch leitenden Flächen des Musters einer elektrisch leitenden Lage und insbesondere zum Beispiel der unteren/untersten elektrisch leitenden Lage geführt und damit verbunden werden. Am Anschlusspunkt können dabei mehrere Kontakte vorgesehen werden, die bevorzugt zum Beispiel mit mehreren und insbesondere zum Beispiel vier oder fünf oder sechs oder sieben beziehungsweise mit allen durchgehenden elektrisch leitenden Flächen des Musters einer elektrisch leitenden Lage und insbesondere der unteren/untersten elektrisch leitenden Lage, welche an den Anschlusspunkt angrenzen und/oder zumindest teilweise darüber liegen, verbunden sein können, wobei zudem zu diesen Flächen des Musters einer elektrisch leitenden Lage und insbesondere zum Beispiel der unteren/untersten elektrisch leitenden Lage darüber hinaus mindestens ein Kontakt, welcher den Pluspol einer/ jeder Gruppe von mindestens zwei über mindestens zwei elektrisch leitende Lagen in Serie geschalteten Solarzellen darstellen kann, und mindestens ein Kontakt, welcher den Minuspol einer/ jeder Gruppe von mindestens zwei über mindestens zwei elektrisch leitende Lagen in Serie geschalteten Solarzellen darstellen kann, jeweils geführt werden, um gegebenenfalls damit verbunden zu werden. Der Anschlusspunkt kann zudem mindestens eine und bevorzugt genau eine Anschlussbuchse umfassen, die mit den am Anschlusspunkt vorgesehenen Kontakten verbunden sein, um den durch die mit der Rückkontaktfolie verbundenen Solarzellen produzierten Strom über eine Anschlussbüchse abzuführen und/oder gegebenenfalls mehrere Solarmodule über eine Anschlussbüchse miteinander zu verbinden. Des Weiteren können in einer Anschlussbuchse mehrere Bypass-Dioden vorgesehen sein, sodass bevorzugt jeder Solarzellstring gegebenenfalls umgangen werden kann. Bevorzugt kann dabei pro Solarzellstring zum Beispiel eine Bypass-Dioden vorgesehen sein. Die durchgehenden elektrisch leitenden Flächen des Musters einer elektrisch leitenden Lage und insbesondere zum Beispiel der unteren/untersten elektrisch leitenden Lage, die an dem Anschlusspunkt angrenzen und/oder zumindest teilweise darüber liegen können dabei zum Beispiel gegebenenfalls die durchgehenden elektrisch leitenden Flächen des Musters einer elektrisch leitenden Lage und insbesondere zum Beispiel der unteren/untersten elektrisch leitenden Lage sein, die direkt um den Anschlusspunkt/eine Anschlussbuchse herum und/oder zumindest teilweise über dem Anschlusspunkt/eine Anschlussbuchse liegen. Direkt um den Anschlusspunkt/eine Anschlussbuchse herum und/oder an den Anschlusspunkt angrenzen kann dabei zum Beispiel bedeuten, dass zwischen dem Anschlusspunkt/einer Anschlussbuchse und den an dem Anschlusspunkt angrenzenden und/oder direkt um den Anschlusspunkt/eine Anschlussbuchse herum angeordneten durchgehenden elektrisch leitenden Flächen des Musters einer elektrisch leitenden Lage und insbesondere zum Beispiel der unteren/untersten elektrisch leitenden Lage keine weiteren elektrisch leitenden Flächen und/oder elektrisch leitenden Elemente des Musters einer elektrisch leitenden vorgesehen/angeordnet sind. Zumindest teilweise über einem Anschlusspunkt/einer Anschlussbuchse oder angrenzend daran liegende durchgehende elektrisch leitende Flächen des Musters einer elektrisch leitenden Lage und insbesondere zum Beispiel der unteren/untersten elektrisch leitenden Lage können dabei so angeordnet sein, dass der Anschlusspunkt/einer Anschlussbuchse zumindest teilweise darunter und/oder angrenzend beziehungsweise angrezend zumindest teilweise darunter angeordnet ist.

Durch einen einzigen Anschlusspunkt kann dabei gegebenenfalls zum Beispiel auf eine Querverschaltung verzichtet werden, da alle Solarzellen, die mit der Rückkontaktfolie verbunden werden, über mindestens zwei elektrisch leitende Lagen und unter anderen auch über die am Anschlusspunkt angrenzenden vorgesehenen durchgehenden elektrisch leitenden Flächen und/oder über die am Anschlusspunkt vorgesehenen Kontakte und/oder die am Anschlusspunkt vorgesehene Anschlussbüchse gegebenenfalls auch ohne Querverschaltung alle in Serie geschaltet werden können. Demnach kann die Gestaltung der Rückkontaktfolie weiter vereinfacht werden. Ein Anschlusspunkt weist demnach keine Querverschaltung auf, da am Anschlusspunkt lediglich mindestens ein und/oder bevorzugt mindestens zwei Kontakte jeder Gruppe von mindestens zwei Solarzellen, die über mindestens zwei elektrisch leitende Lagen in Serie geschaltet sind, der/die den Pluspol und/oder den Minuspol der Gruppe von mindestens zwei in Serie geschalteten Solarzellen darstellen, zusammen kommen und keine Querverschaltung vorgesehen sein kann. Dadurch dass keine Querverschaltung normalerweise im Randbereich vorgesehen ist, kann der vorhandene Platz durch Solarzellen und/oder Solarmodule besser genutzt werden, da der Randbereich, der wegen einer Querverschaltung nicht zur Stromerzeugung genutzt werden kann, bei einem Verzicht auf eine Querverschaltung weniger breit gestaltet werden kann.

In einer Ausführungsform der mehrlagigen Rückkontaktfolie kann/können mindestens eine beziehungsweise mindestens zwei Lage(n) Durchbrüche aufweist/aufweisen.

Dabei können insbesondere zum Beispiel mindestens eine elektrisch leitende Lage und mindestens eine elektrisch nicht leitende Lage Durchbrüche aufweisen. Durchbrüche können dabei zum Beispiel insbesondere materialfreie Stellen beziehungsweise Löcher darstellen. Insbesondere kann dabei zum Beispiel mindestens eine elektrisch leitende Lage Durchbrüche aufweisen und über mindestens einer elektrisch nicht leitenden Lage angeordnet sein, die ebenfalls Durchbrüche aufweisen kann. Die Durchbrüche können dabei zum Beispiel so angeordnet sein, dass die Position der Durchbrüche in den Lagen übereinstimmt beziehungsweise dass die Durchbrüche in den Lagen gegenüber voneinander angeordnet sein können. Dadurch kann durch die Durchbrüche in mindestens einer elektrisch leitenden Lage und/oder in mindestens einer elektrisch nicht leitenden Lage hindurch gegebenenfalls zum Beispiel mindestens eine weitere Lage und insbesondere eine weitere elektrisch leitende Lage erreicht werden. Eine weitere Lage und insbesondere eine weitere elektrisch leitende Lage, die durch die Durchbrüche in mindestens einer elektrisch leitenden Lage und/oder in mindestens einer elektrisch nicht leitenden Lage hindurch, erreicht werden kann, kann dabei bevorzugt zum Beispiel unter mindestens einer elektrisch leitenden Lage mit Durchbrüchen und/oder unter mindestens einer elektrisch nicht leitenden Lage mit Durchbrüchen liegen.

"Oben" kann bei einer erfindungsgemäßen mehrlagigen Rückkontaktfolie insbesondere zum Beispiel die Seite einer erfindungsgemäßen mehrlagigen Rückkontaktfolie sein, welche dafür vorgesehen ist, den Solarzellen zugewandt beziehungsweise am nächsten zu sein und/oder welche den Solarzellen zugewandt beziehungsweise am nächsten ist. "Unten" kann bei einer erfindungsgemäßen mehrlagigen Rückkontaktfolie insbesondere zum Beispiel die Seite einer erfindungsgemäßen mehrlagigen Rückkontaktfolie sein, welche dafür vorgesehen ist von den Solarzellen abgewandt beziehungsweise am weitesten weg zu sein und/oder welche von den Solarzellen abgewandt beziehungsweise am weitesten weg ist. "Von oben nach unten" können die einzelnen Lagen untereinander angeordnet sein, sodass eine Lage jeweils unter einer weiteren Lage angeordnet sein kann. "Von unten nach oben" können die einzelnen Lagen übereinander angeordnet sein, sodass eine Lage jeweils über einer anderen Lage angeordnet sein kann.

Die Durchbrüche können dabei zum Beispiel durch Abtragen und/oder Perforieren und/oder Laser-Perforieren und/oder Stanzen und/oder Ätzen mit einer frei wählbaren Form hergestellt werden.

Insbesondere können dabei zum Beispiel kreisförmige Durchbrüche beziehungsweise Löcher beziehungsweise Perforationen vorgesehen sein. Der Durchmesser der Perforationen kann dabei zum Beispiel zwischen 0,5 mm und 10 mm, bevorzugt zwischen 0,75 mm und 5mm, weiter bevorzugt zwischen 1 mm und 3, weiter bevorzugt zwischen 5 µm und 500 µm, weiter bevorzugt zwischen 10 µm und 200 µm, weiter bevorzugt zwischen 15 µm und 150 µm, weiter bevorzugt zwischen 25 µm und 125 µm, weiter bevorzugt zwischen 30 µm und 80 µm betragen.

Durch die Durchbrüche in bestimmten Lagen kann eine elektrisch leitende Lage gegeben falls durch darüber gelegene Lage hindurch zumindest mit einem Teil der Rückkontakte einer/jeder Solarzelle elektrisch verbunden werden.

Mindestens zwei Lagen können dabei zum Beispiel Unterschiede bezüglich der Anzahl und/oder der Anordnung und/oder der Größe der Durchbrüche aufweisen. Eine Lage kann dabei zum Beispiel mehr oder weniger Durchbrüche als eine weitere bevorzugt zum Beispiel direkt darunter oder darüber angeordnete Lage aufweisen. Darüber hinaus kann zum Beispiel eine unterschiedliche Anordnung der Durchbrüche vorgesehen sein, sodass zumindest ein Teil der Durchbrüche einer Lage an den gleichen Stellen wie beziehungsweise gegenüber von Durchbrüche(n) in einer weiteren Lage angeordnet sein kann und zumindest ein anderer Teil der Durchbrüche einer Lage an Stellen angeordnet sein kann, an denen diese/eine weitere Lage keine Durchbrüche aufweist. Eine direkt unter einer Lage angeordnete Lage kann dabei eine Lage sein, die unter einer Lage angeordnet ist, sodass zwischen der direkt unter der ersten Lage angeordneten Lage und der ersten Lage keine weitere Lage vorgesehen ist.

Eine elektrisch nicht leitende Lage kann dabei insbesondere zum Beispiel mehr Durchbrüche als eine weitere bevorzugt zum Beispiel direkt darunter angeordnete elektrisch leitende Lage aufweisen. Eine elektrisch leitende Lage kann dabei insbesondere zum Beispiel weniger Durchbrüche als eine weitere bevorzugt zum Beispiel direkt darüber angeordnete elektrisch nicht leitende Lage aufweisen. Ein Teil der Durchbrüche einer elektrisch nicht leitenden Lage mit mehr Durchbrüchen als eine bevorzugt zum Beispiel direkt darunter liegende elektrisch leitende Lage kann dabei bevorzugt zum Beispiel an den gleichen Stellen wie beziehungsweise gegenüber von Durchbrüche(n) in einer direkt darunter liegenden elektrisch leitenden Lage angeordnet sein. Ein anderer Teil der einer elektrisch nicht leitenden Lage mit mehr Durchbrüchen als eine bevorzugt zum Beispiel direkt darunter liegende elektrisch leitende Lage kann dabei an Stellen angeordnet sein, an denen bevorzugt zum Beispiel die weitere direkt darunter liegende elektrisch leitende Lage keine Durchbrüche aufweist. Eine elektrisch nicht leitende Lage mit mehr Durchbrüchen als eine bevorzugt zum Beispiel direkt darunter liegende elektrisch leitende Lage kann demnach zum Beispiel sowohl Durchbrüche aufweisen, die nicht gegenüber den Durchbrüchen einer direkt darunter liegenden elektrisch leitenden Lage angeordnet sind, als auch Durchbrüche aufweisen, die gegenüber den Durchbrüchen der darunter liegenden elektrisch leitenden Lage angeordnet sind. Zudem kann bevorzugt zum Beispiel eine direkt unter der elektrisch nicht leitenden Lage mit mehr Durchbrüchen liegende obere/oberste elektrisch leitende Lage mit weniger Durchbrüchen bevorzugt zum Beispiel Durchbrüche aufweisen, die sowohl gegenüber mindestens eines Teils der Durchbrüche der darüber liegenden elektrisch nicht leitenden Lage als auch gegenüber den Durchbrüchen einer weiteren darunter liegenden elektrisch nicht leitenden Lage angeordnet sind. Des Weiteren können mindestens zwei Lagen zum Beispiel Unterschiede bezüglich der Größe der Durchbrüche aufweisen. Insbesondere kann zum Beispiel eine elektrisch leitende Lage größere Durchbrüche als mindestens eine gegebenenfalls darüber und/oder darunter beziehungsweise direkt darüber und/oder direkt darunter angeordnete nicht eklektisch leitende Lage aufweisen, um einen elektrischen Kontakt zwischen der elektrisch leitenden Lage mit den größeren Durchbrüchen und mindestens einem Lot und/oder einem elektrisch leitenden Kleber, welcher/welches insbesondere zum Beispiel beim Verbinden beziehungsweise beim unmittelbaren Verbinden mindestens eines Teils der Rückkontakte einer/jeder Solarzelle mit mindestens einer jenseits/unter der elektrisch nicht leitenden Lage angeordneten weiteren elektrisch leitenden Lage verwendet werden kann, möglichst zu verhindern. Die jenseits/unter der elektrisch nicht leitenden Lage angeordnete weitere elektrisch leitende Lage kann dabei durch die Durchbrüche mehrerer Lagen hindurch und insbesondere zum Beispiel auch durch die größeren Durchbrüche in der elektrisch leitenden Lage mit größeren Durchbrüchen hindurch insbesondere zum Beispiel durch mindestens ein Lot und/oder mindestens einen elektrisch leitenden Kleber mit mindestens einem Teil der Rückkontakte einer/jeder Solarzelle verbunden werden. In der Tat kann insbesondere zum Beispiel dank der an den größeren Durchbrüchen in der elektrisch leitenden Lage freigelegten darunter liegenden elektrisch nicht leitenden Lage ein elektrischer Kontakt zwischen der elektrisch leitenden Lage mit größeren Durchbrüchen und mindestens einem Lot und/oder mindestens einem elektrisch leitenden Kleber, welcher zum Beispiel insbesondere durch diese Durchbrüche sowie durch die kleineren Durchbrüche der darüber und/oder darunter beziehungsweise direkt darüber und/oder direkt darunter liegenden elektrisch nicht leitenden Lage zu einer jenseits davon beziehungsweise darunter angeordneten weiteren unteren/untersten elektrisch leitenden Lage reichen kann, möglichst verhindert werden. Insbesondere kann zum Beispiel eine elektrisch leitende Lage größere Durchbrüche als mindestens eine darunter beziehungsweise direkt darunter und mindestens eine weitere zusätzliche darüber beziehungsweise direkt darüber angeordnete nicht elektrisch leitende Lage aufweisen, um einen elektrischen Kontakt zwischen der elektrisch leitenden Lage mit den größeren Durchbrüchen und mindestens einem Lot und/oder einem elektrisch leitenden Kleber, welcher/welches insbesondere zum Beispiel beim Verbinden beziehungsweise beim unmittelbaren Verbinden mindestens eines Teils der Rückkontakte einer/jeder Solarzelle mit mindestens einer unter der unteren elektrisch nicht leitenden Lage angeordneten weiteren elektrisch leitenden Lage verwendet werden kann, möglichst zu verhindern. Mindestens eine unter der unteren elektrisch nicht leitenden Lage angeordnete elektrisch leitende Lage kann durch die Durchbrüche mehrerer Lagen hindurch und gegebenenfalls zum Beispiel durch die Durchbrüche in einer weiteren zusätzlichen oberen elektrisch nicht leitenden Lage, durch die Durchbrüche in einer oberen elektrisch leitenden Lage mit größeren Durchbrüchen, durch die Durchbrüche in einer unteren elektrisch nicht leitenden Lage hindurch insbesondere zum Beispiel durch mindestens ein Lot und/oder mindestens einen elektrisch leitenden Kleber mit mindestens einem Teil der Rückkontakte einer/jeder Solarzelle verbunden werden. Ferner kann insbesondere zum Beispiel dank der an den größeren Durchbrüchen in einer oberen elektrisch leitenden Lage freigelegten darunter liegenden unteren elektrisch nicht leitenden Lage ein elektrischer Kontakt zwischen der elektrisch leitenden Lage mit größeren Durchbrüchen und mindestens einem Lot und/oder mindestens einem elektrisch leitenden Kleber, welcher zum Beispiel insbesondere durch diese Durchbrüche sowie durch die kleineren Durchbrüche der darüber und darunter beziehungsweise direkt darüber und direkt darunter liegenden elektrisch nicht leitenden Lagen zu einer unter der unteren/untersten elektrisch nicht leitenden Lage angeordneten weiteren elektrisch leitenden Lage reichen kann, möglichst verhindert werden. Durch die Durchbrüche in bestimmten Lagen kann eine elektrisch leitende Lage demnach gegebenenfalls durch darüber gelegene Lagen hindurch zumindest mit einem Teil der Rückkontakte einer/jeder Solarzelle elektrisch verbunden werden.

In einer Ausführungsform der mehrlagigen Rückkontaktfolie kann mindestens eine elektrisch leitende Lage mindestens ein elektrisch leitendes Material, wie zum Beispiel insbesondere mindestens ein Metall und/oder mindestens eine Metalllegierung umfassen. Ein Metall kann dabei zum Beispiel Gold, Silber, Kupfer, Aluminium, Nickel, Eisen, Blei, Zink, Zinn sein. Eine Metalllegierung kann dabei insbesondere zum Beispiel eine Metalllegierung, wie zum Beispiel Stahl beziehungsweise Edelstahl, sein, welche bevorzugt zum Beispiel mindestens eins und bevorzugt mindestens zwei der vorgenannten Metalle umfasst. Alternativ kann eine elektrisch leitende Lage gegebenenfalls zum Beispiel auch mindestens ein elektrisch leitendes Material, wie zum Beispiel mindestens ein organisches elektrisch leitendes Material, wie zum Beispiel insbesondere ein elektrisch leitendes Polymer und/oder ein mit Kohlenstoffpartikeln, Fullerenen oder Kohlenstoff-Nanoröhren oder nanometrische Graphen-Plättchen dotiertes Polymer umfassen. Darüber hinaus kann eine elektrisch leitende Lage alternativ gegebenenfalls zum Beispiel auch mindestens ein elektrisch leitendes Oxid und insbesondere zum Beispiel mindestens ein elektrisch leitendes Oxid mindestens der vorgenannten Metalle umfassen. Dadurch kann gegebenenfalls eine sehr gute elektrische Leitfähigkeit erreicht werden, um elektrischen Strom effektiv abzuleiten.

In einer Ausführungsform der mehrlagigen Rückkontaktfolie kann mindestens eine elektrisch nicht leitende Lage mindestens ein Polymer umfassen. Ein Polymer kann dabei bevorzugt ein elektrisch nicht leitendes Polymer sein. Ein Polymer kann dabei zum Beispiel mindestens ein Polyolefin, wie zum Beispiel insbesondere Polyethylen und/oder Polypropylen, Polyisopren (PI), Poyethylenterephtalate (PET), Poyethylennaphtalate (PEN), ein Ethylenvinylacetat-Copolymer (EVA), ein Polyacrylat, ein Polymethacrylat, ein Polyurethan, ein Epoxidharz, ein Polyester, Polyvinylbutiral (PVB), Polyvinylfluoride (PVF), Polyvinylchloride (PVC) und/oder mindestens eine Mischung und/oder mindestens ein Copolymer davon umfassen. Zudem kein ein Polymer auch ein verstärktes Polymer und insbesondere zum Beispiel ein mit Glasfaser verstärktes Polymer darstellen. Dadurch können mindestens zwei elektrisch leitende Lagen durch mindestens eine dazwischen angeordnete elektrisch nicht leitende Lage effektiv elektrisch isoliert werden, um unerwünschte elektrische Kontakte zwischen zwei elektrisch leitenden Lagen weitestgehend zu verhindern.

In einer Ausführungsform der mehrlagigen Rückkontaktfolie kann die mehrlagige Rückkontaktfolie zum Beispiel mindestens eine und/oder bevorzugt zum Beispiel mindestens zwei, weiter bevorzugt zum Beispiel mindestens drei, weiter bevorzugt zum Beispiel mindestens vier, weiter bevorzugt zum Beispiel mindestens fünf, weiter bevorzugt zum Beispiel mindestens sechs, weiter bevorzugt zum Beispiel mindestens sieben, weiter bevorzugt zum Beispiel mindestens acht, weiter bevorzugt zum Beispiel mindestens neun zusätzliche elektrisch nicht leitende Lage(n) umfassen. Mindestens eine und/oder mindestens zwei zusätzliche elektrisch nicht leitende Lage(n) kann/können dabei bevorzugt zum Beispiel über einer ersten/oberen/obersten elektrisch leitenden Lage und/oder unter einer weiteren/unteren/untersten elektrisch leitenden Lage angeordnet sein. In einer Ausführungsform einer mehrlagigen Rückkontaktfolie kann/können mindestens eine und/oder mindestens zwei zusätzliche elektrisch nicht leitende Lage (n) bevorzugt zum Beispiel über einer ersten/oberen/obersten elektrisch leitenden Lage und mindestens einer elektrisch nicht leitende Lage und/oder bevorzugt zum Beispiel unter einer weiteren/unteren/untersten elektrisch leitenden Lage angeordnet sein. Mindestens eine und/oder mindestens zwei zusätzliche elektrisch nicht leitende Lage(n) kann/können dabei bevorzugt zum Beispiel alternativ auch über und/oder unter einer weiteren/unteren/untersten elektrisch nicht leitenden Lage angeordnet sein. In Ausführungsform einer mehrlagigen Rückkontaktfolie kann/können mindestens eine und/oder mindestens zwei zusätzliche elektrisch nicht leitende Lage(n) bevorzugt zum Beispiel über einer zusätzlichen elektrisch nicht leitenden Lage und einer ersten/oberen/obersten elektrisch leitenden Lage und mindestens einer darunter beziehungsweise direkt darunter liegenden elektrisch nicht leitende Lage und/oder bevorzugt zum Beispiel unter einer weiteren/unteren/untersten elektrisch leitenden Lage angeordnet sein.

Eine zusätzliche elektrisch nicht leitende Lage kann dabei insbesondere zum Beispiel eine elektrisch nicht leitende Abdecklackschicht und insbesondere eine Epoxidharzschicht darstellen, welche gegebenenfalls über mindestens einer elektrisch leitenden Lage und bevorzugt über der oberen/obersten elektrisch leitenden Lage angeordnet werden kann. Eine zusätzliche elektrisch nicht leitende Lage und/oder insbesondere zum Beispiel eine Abdecklackschicht beziehungsweise eine Epoxidharzschicht kann dabei zum Beispiel vollflächig beziehungsweise fast vollflächig auf mindestens einer elektrisch leitenden Lage und/oder insbesondere auf der oberen/obersten elektrisch leitenden Lage aufgebracht werden. Sofern eine zusätzliche elektrisch nicht leitende Lage und/oder insbesondere zum Beispiel eine Abdecklackschicht beziehungsweise eine Epoxidharzschicht fast vollflächig auf mindestens einer elektrisch leitenden Lage und/oder insbesondere auf der oberen/obersten elektrisch leitenden Lage aufgebracht wird, können bevorzugt zum Beispiel lediglich die Bereiche der Durchbrüche in der oberen/obersten beziehungsweise direkt darüber angeordneten elektrisch nicht leitenden Lage beim Aufbringen ausgenommen sein. Durch eine zusätzliche elektrisch nicht leitende Lage und insbesondere zum Beispiel eine Abdecklackschicht beziehungsweise eine Epoxidharzschicht, welche gegebenenfalls über mindestens einer elektrisch leitenden Lage und bevorzugt über der oberen/obersten elektrisch leitenden Lage angeordnet werden kann, kann ein Kontakt der oberen/obersten elektrisch leitenden Lage mit mindestens einem elektrisch leitenden Kleber und/oder mindestens einem Lot, der/das dazu verwendet werden kann durch die Durchbrüche in der oberen/obersten elektrisch leitenden Lage hindurch eine elektrische Verbindung mit der unteren/untersten elektrische leitenden Lage herzustellen, insbesondere im Bereich die Durchbrüche in der oberen/obersten elektrisch leitenden Lage und/oder im Bereich der Aussparungen in der oberen/obersten elektrisch leitenden Lage möglichst verhindert werden. Demnach können unerwünschte Kontakte zwischen zwei elektrisch leitenden Lagen somit gegebenenfalls verhindert werden.

Demnach kann eine mehrlagige Rückkontaktfolie zum Beispiel einen Aufbau gemäß einem der folgenden Beispiele aufweisen.
"Von unten nach oben" kann eine mehrlagige Rückkontaktfolie zum Beispiel in einer Ausführungsform eine elektrisch leitende Lage, eine elektrisch nicht leitende Lage, eine elektrisch leitende Lage und eine zusätzliche elektrisch nicht leitende Lage umfassen.
"Von unten nach oben" kann eine mehrlagige Rückkontaktfolie zum Beispiel in einer weiteren Ausführungsform eine zusätzliche elektrisch nicht leitende Lage, eine elektrisch leitende Lage, eine elektrisch nicht leitende Lage und eine elektrisch leitende Lage umfassen.
"Von unten nach oben" kann eine mehrlagige Rückkontaktfolie zum Beispiel in einer weiteren Ausführungsform eine zusätzliche elektrisch nicht leitende Lage, eine elektrisch leitende Lage, eine elektrisch nicht leitende Lage, eine weitere zusätzliche elektrisch nicht leitende Lage, und eine andere weitere elektrisch leitende Lage umfassen.
"Von unten nach oben" kann eine mehrlagige Rückkontaktfolie zum Beispiel in einer weiteren Ausführungsform mindestens eine zusätzliche elektrisch nicht leitende Lage, wie zum Beispiel eine Dampfsperre und/oder eine Lage zur mechanischen

Verstärkung, eine elektrisch leitende Lage, eine elektrisch nicht leitende Lage, eine weitere elektrisch leitende Lage, eine weitere zusätzliche elektrisch nicht leitende Lage und eine andere weitere zusätzliche elektrisch nicht leitende Lage umfassen. Durch mindestens eine zusätzliche elektrisch nicht leitende Lage, die zum Beispiel über beziehungsweise direkt über der oberen/obersten elektrisch leitenden Lage angeodnet sein kann, kann zum Beispiel die obere/oberste elektrisch leitende Lage von der Rückseite beziehungsweise der von der Sonne abgewandten Seite der Solarzellen elektrisch isoliert und/oder mit den Solarzellen klebend verbunden beziehungsweise verklebt werden. Zudem kann durch mindestens eine zusätzliche elektrisch nicht leitende Lage, die zum Beispiel unter beziehungsweise direkt unter der untereb/untersten elektrisch leitenden Lage angeodnet sein kann, gegebenenfalls zum Beispiel die Unterseite einer mehrlagigen Rückkontaktfolie beziehungsweise der unteren/untersten elektrisch leitenden Lage einer mehrlagigen Rückkontaktfolie elektrisch isoliert und/oder geschützt und/oder verstärkt werden.

In einer Ausführungsform der mehrlagigen Rückkontaktfolie kann die mehrlagige Rückkontaktfolie ein eigenständiges Teil darstellen. Eine mehrlagige Rückkontaktfolie kann dabei ein eigenständiges und/oder manipulierbares Teil darstellen, welches zum elektrischen Verbinden von mindestens zwei Solarzellen verwendet werden kann. Insbesondere können dabei mindestens zwei Gruppen von mindestens zwei Solarzellen durch eine mehrlagige Rückkontaktfolie in Serie geschaltet werden und/oder gegebenenfalls über mindestens eine Bypass-Diode umgangen werden. Dadurch kann die Herstellung von Solarmodulen vereinfacht werden.

Eine mehrlagige Rückkontaktfolie kann dabei zum Beispiel durch Laminieren von mindestens einer bevorzugt von mindestens zwei elektrisch leitenden und mindestens einer elektrisch nicht leitenden Folien hergestellt werden. Beim Laminieren können die einzelnen Folien zum Beispiel unter Druck- und/oder unter Hitzeeinwirkung und/oder bei Unterdruck zu einer mehrlagigen Rückkontaktfolie zusammengefügt werden. Um das Zusammenfügen der einzelnen Lagen zu vereinfachen/zu verbessern kann eine mehrlagige Rückkontaktfolie gegebenenfalls zum Beispiel auch mindestens eine bevorzugt jedoch mehrere zusätzlich Klebelage(n), welche insbesondere zum Beispiel eine und/oder mehrere Klebelage(n) auf Acrylbasis sein kann/können. Jeweils mindestens eine zusätzliche Klebelage kann dabei bevorzugt jeweils zwischen mindesten zwei Lagen einer mehrlagigen Rückkontaktfolie angeordnet werden.

Alternativ kann eine mehrlagige Rückkontaktfolie zum Beispiel gegebenenfalls auch durch Aufbringen von mindestens einer bevorzugt von mindestens zwei elektrisch leitenden Lagen zum Beispiel durch Sputtern und/oder durch galvanisches Abscheiden und/oder durch Gasspritzen auf einer elektrisch nicht leitenden Lage beziehungsweise auf einem elektrisch nicht leitenden Substrat, wie zum Beispiel eine elektrisch nicht leitende Folie, hergestellt werden.

Insbesondere kann eine mehrlagige Rückkontaktfolie zum Beispiel gegebenenfalls auch durch Aufbringen jeweils einer elektrisch leitenden Lage zum Beispiel durch Laminieren einer elektrisch leitenden Folie und/oder durch Sputtern und/oder durch galvanisches Abscheiden und/oder durch Gasspritzen auf jede Seite einer elektrisch nicht leitenden Lage mit Durchbrüchen, wie zum Beispiel eine elektrisch nicht leitende Folie mit Durchbrüchen, hergestellt werden. Eine der aufgebrachten elektrisch leitenden Lagen und insbesondere die obere/oberste aufgebrachte elektrisch leitende Lage beziehungsweise die durchgehenden durch Trennlinien getrennten elektrisch leitenden Flächen mit Durchbrüchen dieser Lage kann/können mindestens eine und bevorzugt mehrere Aussparung(en) beziehungsweise zum Beispiel ringförmige Aussparung(en) mit einer bestimmten Breite aufweisen, die jeweils einen Teil der elektrisch leitenden Lage vom Rest dieser elektrisch leitenden Lage elektrisch isoliert. In der Tat kann eine Aussparung zum Beispiel frei von elektrisch leitendem Material sein, um einen Teil einer elektrisch leitenden Lage vom Rest dieser elektrisch leitenden Lage elektrisch zu isolieren.

Die elektrisch leitenden Lagen die beidseitig auf der elektrisch nicht leitenden Lage mit Durchbrüchen aufgebracht werden können, können durch ihre Herstellungsweise Durchbrüche aufweisen, die so angeordnet sind, dass die Position der Durchbrüche in den elektrisch leitenden Lagen mit der Position der Durchbrüche in der elektrisch nicht leitenden Lage übereinstimmt beziehungsweise dass die Durchbrüche in den elektrisch leitenden Lagen an den gleichen Stellen wie beziehungsweise gegenüber den Durchbrüchen in der elektrisch nicht leitenden Lage angeordnet sind. Die Durchbrüche in der elektrisch nicht leitenden Lage und/oder in den elektrisch leitenden Lagen können dabei bevorzugt kleiner sein als die Durchbrüche in einer zusätzlichen elektrisch leitenden Lage, die gegebenenfalls über einer elektrisch leitenden Lage und insbesondere über einer zusätzlichen elektrisch nicht leitenden Lage angeordnet sein kann, welche direkt über der oberen/obersten elektrisch leitenden Lage liegen kann. Die Durchbrüche in der elektrisch nicht leitenden Lage und/oder in den beidseitig darauf aufgebrachten elektrisch leitenden Lagen können dabei bevorzugt jeweils zum Beispiel innerhalb der durch die Aussparungen und gegebenenfalls insbesondere zum Beispiel durch die ringförmigen Aussparungen vom Rest einer elektrisch leitenden Lage und insbesondere der oberen/obersten elektrisch leitenden Lage getrennten beziehungsweise elektrisch isolierten Teile der elektrisch leitenden Lage und insbesondere der oberen/obersten elektrisch leitenden Lage vorgesehen sein. Die Aussparungen und/oder zum Beispiel ringförmigen Aussparungen in einer elektrisch leitenden Lage und insbesondere in der oberen/obersten elektrisch leitenden Lage beziehungsweise der entsprechende Bereich einer Aussparung können/kann dabei durch eine weitere zusätzliche elektrisch nicht leitende Lage und insbesondere zum Beispiel eine Abdecklackschicht beziehungsweise eine Epoxidharzschicht zumindest teilweise gefüllt/bedeckt werden. Die zusätzliche elektrisch nicht leitende Lage und insbesondere zum Beispiel eine Abdecklackschicht beziehungsweise eine Epoxidharzschicht, welche direkt über einer elektrisch leitenden Lage und insbesondere der oberen/obersten elektrisch leitenden Lage angeordnet sein kann, kann diese Lage bis auf die Bereiche der Durchbrüche in der oberen/obersten nicht elektrisch leitenden Lage und/oder gegebenenfalls einen kleinen Randbereich um diese Durchbrüche herum bevorzugt zum Beispiel ganz bedecken. Durch eine weitere zusätzliche elektrisch nicht leitende Lage und insbesondere zum Beispiel eine Abdecklackschicht beziehungsweise eine Epoxidharzschicht, welche gegebenenfalls über mindestens einer elektrisch leitenden Lage und bevorzugt über der oberen/obersten elektrisch leitenden Lage angeordnet werden kann, kann insbesondere ein Kontakt der oberen/obersten elektrisch leitenden Lage mit mindestens einem elektrisch leitenden Kleber und/oder mindestens einem Lot, der/das dazu verwendet werden kann durch die Durchbrüche in der oberen/obersten elektrisch nicht leitenden Lage hindurch eine elektrische Verbindung mit der unteren/untersten elektrisch leitenden Lage herzustellen. Demnach können unerwünschte Kontakte zwischen zwei elektrisch leitenden Lagen somit gegebenenfalls möglichst verhindert werden. Dabei kann gleichzeitig beim Aufbringen der elektrisch leitenden Lagen und/oder nach dem Aufbringen der elektrisch leitenden Lagen in einem zusätzlichen Arbeitsschritt durch galvanisches Abscheiden und/oder durch Gasspritzen und/oder durch Sputtern in den Durchbrüchen in der elektrisch nicht leitenden Lage und/oder in den beidseitig darauf aufgebrachten elektrisch leitenden Lagen beziehungsweise auf den Seitenwänden der Durchbrüche in der elektrisch nicht leitenden Lage und/oder in den beidseitig darauf aufgebrachten elektrisch leitenden Lagen ebenfalls elektrisch leitendes Material aufgebracht werden. Dadurch kann gegebenenfalls ein elektrischer Kontakt zwischen der unteren/untersten elektrisch leitenden Lage und mindestens einem beziehungsweise jeden Teil der oberen/obersten elektrisch leitenden Lage, die durch mindestens eine Aussparung in der oberen/obersten elektrisch leitenden Lage vom Rest dieser Lage elektrisch isoliert werden, hergestellt werden. Der elektrische Kontakt kann dabei durch galvanisches Abscheiden und/oder durch Gasspritzen und/oder durch Sputtern von elektrisch leitendem Material in den Durchbrüchen in der elektrisch nicht leitenden Lage und/oder in den beidseitig darauf aufgebrachten elektrisch leitenden Lagen beziehungsweise auf den Seitenwänden der Durchbrüche in der elektrisch nicht leitenden Lage und/oder in den beidseitig darauf aufgebrachten elektrisch leitenden Lagen hergestellt werden. Zudem können die Durchbrüche in der unteren und der oberen elektrisch leitenden Lage und die Durchbrüche in der unteren elektrisch nicht leitenden Lage dadurch gegebenenfalls mit elektrisch leitendem Material gefüllt werden. Um dabei einen elektrischen Kontakt zwischen mindestens einem Teil der Rückkontakte einer/jeder Solarzelle mit der unteren/untersten elektrisch leitenden Lage herzustellen, kann dieser Teil der Rückkontakte zum Beispiel durch mindestens ein Lot und/oder mindestens einen elektrisch leitenden Kleber zunächst mit mindestens einem Teil der oberen/obersten elektrisch leitenden Lage verbunden werden, welcher durch mindestens eine Aussparung in der oberen/obersten elektrisch leitenden Lage vom Rest dieser Lage elektrisch isoliert sein kann. Durch die in dem/den Teil(en), der/die vom Rest der oberen/obersten elektrisch leitenden Lage jeweils durch mindestens eine Aussparung in dieser Lage isoliert sein kann/können, gegebenenfalls vorgesehenen Durchbrüche kann dabei, wie beschrieben durch aufgebrachtes elektrisch leitendes Material, ein elektrischer Kontakt zu mindestens einer weiteren und insbesondere zum Beispiel zur unteren/untersten elektrisch leitenden Lage hergestellt werden. Zudem kann gegebenenfalls auch durch die Durchbrüche in der elektrisch nicht leitenden Lage und/oder in den beidseitig darauf aufgebrachten elektrisch leitenden Lagen hindurch zumindest auch teilweise auf einer anderen Seite des elektrisch nicht leitenden Lage und insbesondere auf der Seite der oberen/obersten elektrisch leitenden Lage elektrisch leitendes Material durch Sputtern und/oder durch galvanisches Abscheiden und/oder durch Gasspritzen aufgebracht werden. Dabei kann zum Beispiel durch die Durchbrüche hindurch gegebenenfalls zum Beispiel elektrisch leitendes Material jedoch bevorzugt zum Beispiel jeweils immer nur, um die Durchbrüche herum und insbesondere im Bereich der Aussparungen in der oberen/obersten elektrisch leitenden Lage, welcher nicht durch eine weitere zusätzliche elektrisch nicht leitende Lage und insbesondere zum Beispiel eine Abdecklackschicht beziehungsweise eine Epoxidharzschicht gefüllt/bedeckt ist, aufgebracht werden. In dieser Ausführungsform können mindestens zwei elektrisch leitende Lagen bevorzugt zum Beispiel gleichzeitig insbesondere zum Beispiel durch Sputtern und/oder durch galvanisches Abscheiden und/oder durch Gasspritzen auf beide Seiten einer elektrisch nicht leitenden Lage aufgebracht werden. Dies kann bevorzugt in einem einzigen Arbeitsschritt geschehen. Zudem kann dadurch gegebenenfalls auf ein Laminieren von Folien/Lagen beziehungsweise auf einen Laminierschritt verzichtet werden.

"Von unten nach oben" kann eine mehrlagige Rückkontaktfolie zum Beispiel in einer Ausführungsform eine zusätzliche elektrisch nicht leitende Lage, eine elektrisch leitende Lage, eine elektrisch nicht leitende Lage mit Durchbrüchen und eine elektrisch leitende Lage mit Durchbrüchen, eine weitere zusätzliche elektrisch nicht leitende Lage und eine weitere zusätzliche elektrisch nicht leitende Lage mit Durchbrüchen umfassen. Die obere/oberste zusätzliche elektrisch nicht leitende Lage kann zum Beispiel mehr Durchbrüche als die darunter liegenden Lagen aufweisen und insbesondere zum Beispiel sowohl Durchbrüche aufweisen, die nicht an den gleichen Stellen wie beziehungsweise gegenüber die/den Durchbrüche(n) der direkt darunter liegenden elektrisch leitenden Lage angeordnet sind, als auch Durchbrüche aufweisen, die an den gleichen Stellen wie beziehungsweise gegenüber die/den Durchbrüche(n) der direkt darunter liegenden elektrisch leitenden Lage angeordnet sind. Ferner kann die obere/oberste elektrisch leitende Lage im Vergleich zu einer direkt darunter liegenden elektrisch nicht leitenden Lage zum Beispiel die gleiche Anzahl an Durchbrüchen aufweisen. Des Weiteren können die Durchbrüche der oberen/obersten elektrisch leitenden Lage zum Beispiel größer sein als die Durchbrüche der darüber und darunter liegenden elektrisch nicht leitenden Lagen mit Durchbrüchen. Diese Durchbrüche können zudem zum Beispiel sowohl an den gleichen Stellen wie beziehungsweise gegenüber mindestens ein/einem Teil der Durchbrüche, der direkt darüber liegenden elektrisch nicht leitenden Lage als auch an den gleichen Stellen wie beziehungsweise gegenüber die/den Durchbrüche(n), der darunter liegenden elektrisch nicht leitenden Lage angeordnet sein.

Dadurch kann ein Teil der Rückkontakte einer/jeder Solarzelle, der den Pluspol und/oder den Minuspol einer/jeder Solarzelle darstellt, gegebenenfalls durch die Durchbrüche einer optionalen oberen/obersten gegebenenfalls zusätzlichen elektrisch nicht leitenden Lage mit Durchbrüchen lediglich mit der oberen/obersten elektrisch leitenden Lage der mehrlagigen Rückkontaktfolie unmittelbar verbunden werden. Dabei können diese Rückkontakte bevorzugt nicht mit der unteren/untersten elektrisch leitenden Lage verbunden beziehungsweise unmittelbar verbunden werden. Zudem kann ein anderer Teil der Rückkontakte einer/jeder Solarzelle, der den Pluspol und/oder den Minuspol einer/jeder Solarzelle darstellt, jedoch durch die Durchbrüche einer optionalen oberen/obersten elektrisch nicht leitenden Lage mit Durchbrüchen, einer oberen/obersten elektrisch leitenden Lage mit Durchbrüchen und einer darunter liegenden elektrisch nicht leitenden Lage mit Durchbrüchen lediglich mit der unteren/untersten elektrisch leitenden Lage der mehrlagigen Rückkontaktfolie unmittelbar verbunden werden. Dabei können diese Rückkontakte bevorzugt nicht mit der unteren/untersten elektrisch leitenden Lage verbunden beziehungsweise unmittelbar verbunden werden. Dadurch kann eine besonders bequeme Verbindung/Verschaltung von Solarzellen über eine mehrlagige Rückkontaktfolie gegebenenfalls zum Beispiel ermöglicht werden. Insbesondere können dabei zum Beispiel mindesten zwei Solarzellen über eine mehrlagige Rückkontaktfolie in Serie geschaltet werden, um gegebenenfalls zum Beispiel mindestens eine bevorzugt jedoch mehrere Gruppe(n) von mindestens zwei in Serie geschalteten Solarzellen zu bilden.

Des Weiteren betrifft die vorliegende Erfindung auch ein Verfahren zum Verbinden von Solarzellen, bei dem mindestens eine mehrlagige Rückkontaktfolie verwendet werden kann, um Solarzellen zum Beispiel zur Herstellung eines Solarmoduls zu verbinden. Bevorzugt können dabei zum Beispiel alle Solarzellen, die mit einer mehrlagigen Rückkontaktfolie verbunden werden, in Serie geschaltet werden. Dadurch kann die Herstellung von Solarmodulen gegebenenfalls erheblich vereinfacht werden insbesondere auch wenn mehr als zwei Solarzellstrings, die jeweils über eine Bypass-Diode umgangen werden können, innerhalb eines zu herstellenden Moduls vorgesehen sind und/oder wenn gegebenenfalls zum Beispiel auf eine Querverschaltung verzichtet wird und/oder wenn gegebenenfalls zum Beispiel lediglich ein Anschlusspunkt vorgesehen wird.

In einer Ausführungsform des Verfahrens zum Verbinden von Solarzellen können mindestens zwei elektrisch leitende Lagen einer mehrlagigen Rückkontaktfolie jeweils mit mindestens einem Teil der Rückkontakte jeder Solarzelle verbunden werden beziehungsweise unmittelbar verbunden werden. Dass ein Rückkontakt einer Solarzelle unmittelbar mit einer elektrisch leitenden Lage verbunden sein kann, kann dabei bevorzugt zum Beispiel bedeuten, dass ein Rückkontakt einer Solarzelle durch bloßen Kontakt und/oder durch Löten und/oder durch elektrisch leitendes Kleben direkt beziehungsweise ohne Zwischenschritt beziehungsweise ohne Zwischenteil elektrisch mit einer elektrisch leitenden Lage verbunden sein kann und/oder dass ein Rückkontakt einer Solarzelle bevorzugt zum Beispiel ohne elektrischen Kontakt mit mindestens einem und/oder bevorzugt mehreren Teil(en) einer weiteren elektrisch leitenden Lage, welche(r) nicht elektrisch vom Rest dieser weiteren elektrisch isoliert ist, verbunden sein kann. Jede elektrisch leitende Lage kann dabei gegebenenfalls zum Beispiel zum Kontaktieren der Solarzellen verwendet werden. Bevorzugterweise wird jede elektrisch leitende Lage demnach zum Beispiel zumindest mit einem Teil der Rückkontakt mindestens einer beziehungsweise jeder Solarzelle verbunden beziehungsweise unmittelbar verbunden. Eine elektrisch leitende Lage, die lediglich über mindesten einen Teil einer weiteren elektrisch leitenden Lage, welcher elektrisch vom Rest dieser weiteren elektrisch isoliert ist, mit mindestens einem Teil der Rückkontakte mindestens einer Solarzelle verbunden ist, kann demnach gegebenenfalls zum Beispiel als unmittelbar mit mindestens einem Teil der Rückkontakte mindestens einer Solarzelle verbunden angesehen werden. Eine elektrisch leitende Lage, die über mindestens einen Teil einer weiteren elektrisch leitenden Lage, welcher nicht elektrisch vom Rest dieser weiteren elektrisch leitenden Lage isoliert ist, mit mindestens einem Teil der Rückkontakte mindestens einer Solarzelle verbunden ist, kann dabei gegebenenfalls zum Beispiel lediglich als mit einer gesamten weiteren elektrisch leitenden Lage verbunden beziehungsweise über eine gesamte weitere elektrisch leitende Lage mit mindestens einem Teil der Rückkontakte mindestens einer Solarzelle verbunden angesehen werden. Eine elektrisch leitende Lage, die über eine gesamte weitere elektrisch leitende Lage beziehungsweise über mindesten einen Teil einer weiteren elektrisch leitenden Lage, welcher nicht elektrisch vom Rest dieser weiteren elektrisch leitenden Lage isoliert ist, mit mindestens einem Teil der Rückkontakte mindestens einer Solarzelle verbunden ist, kann dabei demnach gegebenenfalls zum Beispiel somit nicht als unmittelbar mit mindestens einem Teil der Rückkontakte mindestens einer Solarzelle verbunden angesehen werden. Dadurch kann gegebenenfalls ermöglicht werden, dass jede elektrisch leitende Lage jeweils zumindest mit einem Teil der Rückkontakte jeder Solarzelle verbunden beziehungsweise unmittelbar verbunden wird, um die Solarzellen insbesondere zum Beispiel zur Herstellung eines Solarmoduls miteinander zu verbinden und gegebenenfalls zum Beispiel zur Herstellung eines Solarmoduls mindestens zwei Solarzellen bevorzugt zum Beispiel über mindestens zwei elektrisch leitende Lagen einer erfindungsgemäßen mehrlagigen Rückkontaktfolie in Serie zu schalten.

In einer Ausführungsform des Verfahrens zum Verbinden von Solarzellen können für jede Solarzelle jeweils eine elektrisch leitende Lage mit den Rückkontakten, die den Pluspol einer Solarzelle darstellen, und mindestens eine weitere elektrisch leitende Lage mit den Rückkontakten, die den Minuspol der Solarzelle darstellen, verbunden und/oder unmittelbar verbunden werden. Dabei können die Solarzellen gegebenenfalls zum Beispiel so ausgerichtet beziehungsweise gedreht/manipuliert/platziert werden, dass dies ermöglicht wird. Dadurch können zur Herstellung eines Solarmoduls mindestens zwei Solarzellen bevorzugt zum Beispiel über mindestens zwei elektrisch leitende Lagen einer erfindungsgemäßen mehrlagigen Rückkontaktfolie in Serie geschaltet werden.

In einer Ausführungsform des Verfahrens zum Verbinden von Solarzellen können die Rückkontakte, die den Pluspol oder den Minuspol einer Solarzelle darstellen, respektive jeweils mit einer ersten/oberen/obersten elektrisch leitenden Lage und einer zweiten/unteren/untersten elektrisch leitenden Lage verbunden werden, wobei ferner die Rückkontakte, die den Pluspol oder den Minuspol mindestens einer weiteren Solarzelle darstellen, welche mindestens mit der ersten Solarzelle in Serie geschaltet wird, respektive mit der zweiten/unteren/untersten elektrisch leitenden Lage und der ersten/oberen/obersten elektrisch leitenden Lage verbunden werden. Bevorzugt können dabei zum Beispiel für mindestens zwei, bevorzugt mindestens drei, weiter bevorzugt mindestens vier, weiter bevorzugt mindestens fünf, weiter bevorzugt mindestens sechs, weiter bevorzugt mindestens sieben, weiter bevorzugt mindestens acht, weiter bevorzugt mindestens neun, weiter bevorzugt mindestens zehn, weiter bevorzugt mindestens fünfzehn, weiter bevorzugt mindestens sechzehn, weiter bevorzugt mindestens siebzehn, weiter bevorzugt mindestens achtzehn, weiter bevorzugt mindestens zwanzig, weiter bevorzugt mindestens fünfundzwanzig Solarzellen jeweils die Rückkontakte, die den Pluspol oder den Minuspol einer Solarzelle darstellen, respektive jeweils mit einer ersten/oberen/obersten elektrisch leitenden Lage und einer zweiten/unteren/untersten elektrisch leitenden Lage verbunden werden, wobei ferner die Rückkontakte, die den Pluspol oder den Minuspol mindestens einer weiteren Solarzelle darstellen, respektive mit der zweiten/unteren/untersten elektrisch leitenden Lage und der ersten/oberen/obersten elektrisch leitenden Lage verbunden werden, um mindestens eine Gruppe von mindestens zwei Solarzellen zu bilden, die über die mehrlagige Rückkontaktfolie in Serie geschaltet sind. Innerhalb einer Gruppe von mindestens zwei in Serie geschalteten Solarzellen können die Rückkontakte, die den Pluspol oder den Minuspol einer Solarzelle darstellen, für jeweils direkt nacheinander geschaltete Solarzellen, respektive jeweils abwechselnd mit einer ersten/oberen/obersten elektrisch leitenden Lage und einer zweiten/unteren/untersten elektrisch leitenden Lage und mit der zweiten/unteren/untersten elektrisch leitenden Lage und der ersten/oberen/obersten elektrisch leitenden Lage verbunden werden, sodass die Rückkontakte, die den Pluspol oder den Minuspol einer ersten Solarzelle darstellen, respektive jeweils mit einer ersten/oberen/obersten elektrisch leitenden Lage und einer zweiten/unteren/untersten elektrisch leitenden Lage verbunden werden, wobei ferner die Rückkontakte, die den Pluspol oder den Minuspol mindestens einer weiteren direkt nachgeschalteten Solarzelle darstellen, respektive mit der zweiten/unteren/untersten elektrisch leitenden Lage und der ersten/oberen/obersten elektrisch leitenden Lage verbunden werden, wobei ferner die Rückkontakte, die den Pluspol oder den Minuspol mindestens einer zweiten direkt nachgeschalteten Solarzelle darstellen, respektive mit der ersten/oberen/obersten elektrisch leitenden Lage und der zweiten/unteren/untersten elektrisch leitenden Lage verbunden werden, um eine abwechselnde Kontaktierung innerhalb der Gruppe von mindestens zwei Solarzellen zu ermöglichen und mindestens eine Gruppe von mindestens zwei Solarzellen zu bilden, die über die mehrlagige Rückkontaktfolie in Serie geschaltet sind. Zwei direkt nacheinander geschaltete Solarzellen können dabei zwei nachgeschaltete und/oder direkt nachgeschaltete Solarzellen darstellen, wobei dies zum Beispiel bedeuten kann, dass diese Solarzellen, die miteinander verbunden und damit miteinander verschaltet beziehungsweise insbesondere zum Beispiel in Serie geschaltet sind, so miteinander verbunden und damit miteinander verschaltet beziehungsweise insbesondere zum Beispiel in Serie geschaltet sind, dass Strom bei nacheinander geschalteten beziehungsweise nachgeschalteten Solarzellen unmittelbar von einer Solarzelle in die direkt nachgeschaltete Solarzelle fließen kann, beziehungsweise dass zwischen den Solarzellen keine weitere Solarzelle vorgesehen beziehungsweise zwischengeschaltet sein kann. Zwei nacheinander in Serie geschaltete Solarzellen innerhalb einer Gruppe von mindestens zwei in Serie geschalteten Solarzellen beziehungsweise innerhalb eines Solarzell Strings können dabei gegebenenfalls insbesondere zum Beispiel zwei benachbarte Solarzellen sein. Die Rückkontakte, die den Pluspol oder den Minuspol einer Solarzelle darstellen, können dabei zum Beispiel jeweils lediglich einen Teil der Rückkontakte jeder Solarzelle darstellen. Jede Solarzelle kann dabei zum Beispiel mehrere Rückkontakte umfassen, die zum Beispiel den Pluspol der Solarzelle darstellen beziehungsweise die zum Beispiel gemeinsam den Pluspol der Solarzelle darstellen, und zum Beispiel mehrere Rückkontakte umfassen, die zum Beispiel den Minuspol der Solarzelle darstellen beziehungsweise, die zum Beispiel gemeinsam den Minuspol der Solarzelle darstellen. Die Rückkontakte, die jeweils den Pluspol und den Minuspol einer Solarzelle darstellen, können dabei zum Beispiel jeweils getrennt voneinander angeordnet sein, sodass bevorzugt zum Beispiel keine elektrische Verbindung zwischen den Rückkontakten, die den Pluspol einer Solarzelle darstellen, und den Rückkontakten, die den Minuspol einer Solarzelle darstellen, besteht. Dabei können die Solarzellen gegebenenfalls zum Beispiel so ausgerichtet beziehungsweise gedreht/manipuliert/platziert werden, dass dies ermöglicht wird. Dadurch können zur Herstellung eines Solarmoduls mindestens zwei Solarzellen in Serie geschaltet werden beziehungsweise mindestens eine Gruppe von mindestens zwei in Serie geschalteten Solarzellen gebildet werden, um gegebenenfalls zum Beispiel bestimmte Stromstärke- und/oder Leistung- und/oder Spannungsparameter für ein hergestelltes Solarmodul erreicht werden.

In einer Ausführungsform des Verfahrens zum Verbinden von Solarzellen können innerhalb einer Gruppe von mindestens zwei in Serie geschalteten Solarzellen die Rückkontakte, die den Pluspol oder den Minuspol einer Solarzelle darstellen, für jeweils direkt nacheinander geschaltete Solarzellen beziehungsweise benachbarte Solarzellen, zum Beispiel mit einer durchgehenden elektrisch leitenden Fläche einer ersten/oberen/obersten elektrisch leitenden Lage verbunden werden. Die Rückkontakte, die den anderen Pol der Solarzelle darstellen, können dabei mit einer durchgehenden elektrisch leitenden Fläche einer zweiten/unteren/untersten elektrisch leitenden Lage verbunden werden, sodass die Rückkontakte, die den Pluspol oder den Minuspol einer ersten Solarzelle darstellen, respektive jeweils mit einer durchgehenden elektrisch leitenden Fläche einer ersten/oberen/obersten elektrisch leitenden Lage und einer durchgehenden elektrisch leitenden Fläche einer zweiten/unteren/untersten elektrisch leitenden Lage verbunden werden. In Abhängigkeit davon, ob entweder die Rückkontakte, die den Minuspol der ersten Solarzelle darstellen, oder die Rückkontakte, die den Pluspol der ersten Solarzelle darstellen, mit der durchgehenden elektrisch leitenden Fläche der ersten/oberen/obersten elektrisch leitenden Lage verbunden werden, können respektive in ersten Fall die Rückkontakte, die den Pluspol mindestens einer weiteren direkt nachgeschalteten beziehungsweise benachbarten Solarzelle darstellen, oder in zweiten Fall die Rückkontakte, die den Minuspol mindestens einer weiteren direkt nachgeschalteten beziehungsweise benachbarten Solarzelle darstellen, mit der gleichen durchgehenden elektrisch leitenden Fläche der ersten/oberen/obersten elektrisch leitenden Lage verbunden werden. Ferner können in Abhängigkeit davon, ob die Rückkontakte, die den Minuspol der ersten Solarzelle darstellen, oder die Rückkontakte, die den Pluspol der ersten Solarzelle darstellen, mit einer durchgehenden elektrisch leitenden Fläche der zweiten elektrisch leitenden Lage vebunden ist, welche mit der ersten Solarzelle verbunden ist, respektive im ersten Fall die Rückkontakte, die den Pluspol mindestens der weiteren direkt nachgeschalteten beziehungsweise benachbarten Solarzelle darstellen, oder im zweiten Fall die Rückkontakte, die den Minuspol mindestens einer weiteren direkt nachgeschalteten beziehungsweise benachbarten Solarzelle darstellen, mit einer anderen durchgehenden elektrisch leitenden Fläche der zweiten/unteren/untersten elektrisch leitenden Lage, welche nicht mit der ersten Solarzelle verbunden ist, verbunden werden. Zwei direkt nacheinander geschaltete Solarzellen können dabei eine direkt einer anderen Solarzelle nachgeschaltete Solarzelle darstellen, wobei dies zum Beispiel bedeuten kann, dass Solarzellen, die miteinander verbunden und damit miteinander verschaltet beziehungsweise insbesondere zum Beispiel in Serie geschaltet sind, so miteinander verbunden und damit miteinander verschaltet beziehungsweise insbesondere zum Beispiel in Serie geschaltet sind, dass Strom bei nacheinander geschalteten Solarzellen unmittelbar von einer Solarzelle in die direkt nachgeschaltete Solarzelle fließen kann, beziehungsweise dass zwischen den Solarzellen keine weitere Solarzelle vorgesehen beziehungsweise zwischengeschaltet sein kann. Zwei nacheinander in Serie geschaltete Solarzellen innerhalb einer Gruppe von mindestens zwei in Serie geschalteten Solarzellen beziehungsweise innerhalb eines Solarzellstrings können dabei gegebenenfalls insbesondere zum Beispiel zwei benachbarte Solarzellen sein.

Dadurch können Solarzellen und insbesondere benachbarte Solarzellen mit einer erfindungsgemäßen mehrlagigen Rückkontaktfolie besonders bequem jeweils in Serie geschaltet werden.

In einer Ausführungsform des Verfahrens zum Verbinden von Solarzellen können die Rückkontakte, die den Pluspol oder den Minuspol einer Solarzelle darstellen, innerhalb einer Gruppe von mindestens zwei in Serie geschalteten Solarzellen für jeweils direkt nacheinander geschaltete Solarzellen beziehungsweise benachbarte Solarzellen, zum Beispiel mit einer durchgehenden elektrisch leitenden Fläche einer ersten/oberen/obersten elektrisch leitenden Lage verbunden werden. Die Rückkontakte, die den anderen Pol dieser Solarzelle darstellen, können dabei mit einer durchgehenden elektrisch leitenden Fläche einer zweiten/unteren/untersten elektrisch leitenden Lage verbunden werden, sodass die Rückkontakte, die den Pluspol oder den Minuspol einer ersten Solarzelle darstellen, respektive jeweils mit einer durchgehenden elektrisch leitenden Fläche einer ersten/oberen/obersten elektrisch leitenden Lage und einer durchgehenden elektrisch leitenden Fläche einer zweiten/unteren/untersten elektrisch leitenden Lage verbunden werden. In Abhängigkeit davon ob die Rückkontakte, die den Minuspol der ersten Solarzelle darstellen, oder die Rückkontakte, die den Pluspol der ersten Solarzelle darstellen, mit dieser durchgehenden elektrisch leitenden Fläche der zweiten/unteren/untersten elektrisch leitenden Lage verbunden werden, können respektive im ersten Fall die Rückkontakte, die den Pluspol mindestens einer weiteren direkt nachgeschalteten beziehungsweise benachbarten Solarzelle darstellen, oder im zweiten Fall die Rückkontakte, die den Minuspol mindestens einer weiteren direkt nachgeschalteten beziehungsweise benachbarten Solarzelle darstellen, mit der gleichen durchgehenden elektrisch leitenden Fläche der zweiten/unteren/untersten elektrisch leitenden Lage verbunden werden. Ferner können in Abhängigkeit davon, ob die Rückkontakte, die den Minuspol der ersten Solarzelle darstellen, oder die Rückkontakte, die den Pluspol der ersten Solarzelle darstellen, mit der durchgehenden elektrisch leitenden Fläche der ersten/oberen/obersten elektrisch leitenden Lage verbunden sind, welche mit der ersten Solarzelle verbunden ist, respektive im ersten Fall die Rückkontakte, die den Pluspol mindestens einer weiteren direkt nachgeschalteten beziehungsweise benachbarten Solarzelle darstellen, oder im zweiten Fall die Rückkontakte, die den Minuspol mindestens einer weiteren direkt nachgeschalteten beziehungsweise benachbarten Solarzelle darstellen, mit einer anderen durchgehenden elektrisch leitenden Fläche der ersten/oberen/obersten elektrisch leitenden Lage, welche nicht mit der ersten Solarzelle verbunden ist, verbunden werden. Dadurch können Solarzellen und insbesondere benachbarte Solarzellen mit einer erfindungsgemäßen mehrlagigen Rückkontaktfolie besonders bequem jeweils in Serie geschaltet werden.

In einer Ausführungsform des Verfahrens zum Verbinden von Solarzellen können die Rückkontakte, die den Pluspol oder den Minuspol einer Solarzelle darstellen, innerhalb einer Gruppe von mindestens zwei in Serie geschalteten Solarzellen für jeweils direkt nacheinander geschaltete Solarzellen beziehungsweise benachbarte Solarzellen, zum Beispiel mit einer durchgehenden elektrisch leitenden Fläche einer ersten/oberen/obersten elektrisch leitenden Lage verbunden werden. Die Rückkontakte, die den anderen Pol dieser Solarzelle darstellen, können dabei mit einer durchgehenden elektrisch leitenden Fläche einer zweiten/unteren/untersten elektrisch leitenden Lage verbunden werden, sodass die Rückkontakte, die den Pluspol oder den Minuspol einer ersten Solarzelle darstellen, respektive jeweils mit einer durchgehenden elektrisch leitenden Fläche einer ersten/oberen/obersten elektrisch leitenden Lage und einer durchgehenden elektrisch leitenden Fläche einer zweiten/unteren/untersten elektrisch leitenden Lage verbunden werden. In Abhängigkeit davon, ob die Rückkontakte, die den Minuspol der ersten Solarzelle darstellen, oder die Rückkontakte, die den Pluspol der ersten Solarzelle darstellen, mit dieser durchgehenden elektrisch leitenden Fläche der zweiten/unteren/untersten elektrisch leitenden Lage verbunden werden, können respektive im ersten Fall die Rückkontakte, die den Pluspol mindestens einer zweiten Solarzellen darstellen, welche eine weitere direkt nachgeschaltete und/oder benachbarte Solarzelle sein kann, oder im zweiten Fall die Rückkontakte, die den Minuspol mindestens einer zweiten Solarzellen darstellen, welche eine weitere direkt nachgeschaltete und/oder benachbarte Solarzelle sein kann, zum Beispiel mit der gleichen durchgehenden elektrisch leitenden Fläche der zweiten/unteren/untersten elektrisch leitenden Lage verbunden werden. Ferner können in Abhängigkeit davon, ob die Rückkontakte, die den Minuspol der ersten Solarzelle darstellen, oder die Rückkontakte, die den Pluspol der ersten Solarzelle darstellen, mit der durchgehenden elektrisch leitenden Fläche der ersten/oberen/obersten elektrisch leitenden Lage verbunden sind, welche mit der ersten Solarzelle verbunden ist, respektive im ersten Fall die Rückkontakte, die den Pluspol mindestens einer zweiten Solarzellen darstellen, welche eine weitere direkt nachgeschaltete und/oder benachbarte Solarzelle sein kann, oder im zweiten Fall die Rückkontakte, die den Minuspol mindestens einer zweiten Solarzellen darstellen, welche eine weitere direkt nachgeschaltete und/oder benachbarte Solarzelle sein kann, mit einer anderen durchgehenden elektrisch leitenden Fläche der ersten/oberen/obersten elektrisch leitenden Lage verbunden ist, welche nicht mit der ersten Solarzelle verbunden ist, verbunden werden. Ferner können in Abhängigkeit davon, ob die Rückkontakte, die den Minuspol der zweiten Solarzelle darstellen, oder die Rückkontakte, die den Pluspol der zweiten Solarzelle darstellen, mit einer weiteren anderen durchgehenden elektrisch leitenden Fläche der ersten/oberen/obersten elektrisch leitenden Lage, welche nicht mit der ersten Solarzelle verbunden ist, respektive im ersten Fall die Rückkontakte, die den Pluspol mindestens einer dritten direkt der zweiten Solarzelle nachgeschalteten beziehungsweise mit der zweiten Solarzelle benachbarten Solarzelle darstellen, oder im zweiten Fall die Rückkontakte, die den Minuspol mindestens einer dritten direkt der zweiten Solarzelle nachgeschalteten beziehungsweise mit der zweiten Solarzelle benachbarten Solarzelle darstellen, mit der gleichen anderen durchgehenden elektrisch leitenden Fläche der ersten/oberen/obersten elektrisch leitenden Lage verbunden sind, welche nicht mit der ersten Solarzelle verbunden ist, verbunden werden. Zudem können die Rückkontakte, die den anderen Pol der dritten Solarzelle darstellen, mit einer weiteren anderen durchgehenden elektrisch leitenden Fläche der zweiten/unteren/untersten elektrisch leitenden Lage, welche nicht mit der ersten Solarzelle verbunden ist, verbunden werden. Des Weiteren können in Abhängigkeit davon, ob die Rückkontakte, die den Minuspol der dritten Solarzelle darstellen, oder die Rückkontakte, die den Pluspol der dritten Solarzelle darstellen, mit dieser weiteren anderen durchgehenden elektrisch leitenden Fläche der zweiten/unteren/untersten elektrisch leitenden Lage, welche nicht mit der ersten Solarzelle verbunden ist, respektive im ersten Fall die Rückkontakte, die den Pluspol mindestens einer vierten direkt der dritten Solarzelle nachgeschalteten beziehungsweise mit der dritten Solarzelle benachbarten Solarzelle darstellen, oder im zweiten Fall die Rückkontakte, die den Minuspol mindestens einer vierten direkt der zweiten Solarzelle nachgeschalteten beziehungsweise mit der zweiten Solarzelle benachbarten Solarzelle darstellen, mit der gleichen anderen durchgehenden elektrisch leitenden Fläche der zweiten/unteren/untersten elektrisch leitenden Lage, welche nicht mit der ersten Solarzelle verbunden ist, verbunden werden. Darüber hinaus können die Rückkontakte, die den anderen Pol der vierten Solarzelle darstellen, mit einer weiteren anderen durchgehenden elektrisch leitenden Fläche der ersten/oberen/obersten elektrisch leitenden Lage, welche weder mit der ersten Solarzelle noch mit der zweiten Solarzelle verbunden ist, verbunden werden. Dadurch können Solarzellen und insbesondere benachbarte Solarzellen mit einer erfindungsgemäßen mehrlagigen Rückkontaktfolie besonders bequem jeweils in Serie geschaltet werden.

In einer Ausführungsform des Verfahrens zum Verbinden von Solarzellen kann/können mindestens eine Gruppe beziehungsweise bevorzugt mindestens zwei, weiter bevorzugt mindestens drei, weiter bevorzugt mindestens vier, weiter bevorzugt mindestens fünf, weiter bevorzugt mindestens sechs, weiter bevorzugt mindestens sieben, weiter bevorzugt mindestens acht, weiter bevorzugt mindestens neun, weiter bevorzugt mindestens zehn, weiter bevorzugt mindestens elf, weiter bevorzugt mindestens zwölf, weiter bevorzugt mindestens dreizehn, weiter bevorzugt mindestens vierzehn, weiter bevorzugt mindestens fünfzehn, weiter bevorzugt mindestens zwanzig Gruppen von mindestens zwei Solarzellen über mindestens zwei elektrisch leitende Lagen einer mehrlagigen Rückkontaktfolie in Serie geschaltet werden und gegebenenfalls zum Beispiel über mindestens eine Bypass-Diode jeweils umgangen werden. Dadurch kann zum Beispiel zur Herstellung eines Solarmoduls mindestens eine und bevorzugt mehrere Gruppe(n) von mindestens zwei in Serie geschalteten Solarzellen gebildet werden und gegebenenfalls zum Beispiel über mindestens eine Bypass-Diode jeweils umgangen werden, um gegebenenfalls zum Beispiel bestimmte Stromstärke- und/oder Leistung- und/oder Spannungsparameter für ein hergestelltes Solarmodul insbesondere zum Beispiel auch im Falle der Abschattung eines Teils eines Solarzellstrings und/oder im Falle eines Fehlers beziehungsweise einer Stromkreisunterbrechung insbesondere zum Beispiel innerhalb eines Solarzellstrings gegebenenfalls zu optimieren.

In einer Ausführungsform des Verfahrens zum Verbinden von Solarzellen kann/können mindestens eine und bevorzugt mindestens zwei Gruppen von mindestens zwei in Serie geschalteten Solarzellen über mindestens zwei elektrisch leitende Lagen einer mehrlagigen Rückkontaktfolie mit einem bevorzugt gegebenenfalls einzigen Anschlusspunkt verbunden sein. Dadurch kann gegebenenfalls auf eine Querverschaltung verzichtet werden.

Zeichnungen:

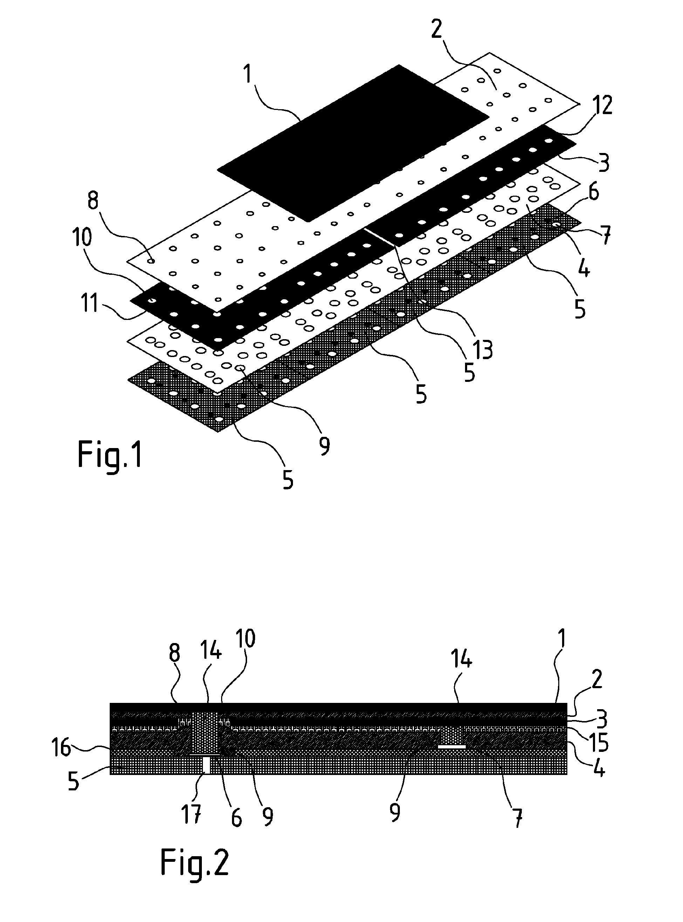

Fig. 1 zeigt eine Explosionsansicht einer mehrlagigen Rückkontaktfolie mit zwei elektrisch leitenden Lagen (1,3) und zwei elektrisch nicht leitenden Lagen (2,4).

Zudem werden auch vier Solarzellen (5) mit ihren Rückkontakten (6,7) dargestellt. Darüber hinaus weisen die zwei elektrisch nicht leitenden Lagen (2,4) Durchbrüche (8,9) auf. Auch die elektrisch leitende Lage (3) weist Durchbrüche (10) auf. Des Weiteren wird von der elektrisch leitenden Lage (3) lediglich ein Teil dargestellt, das zwei rechteckigen durchgehenden elektrisch leitenden Flächen (11,12) der elektrisch leitenden Lage (3) entspricht, welche jeweils von einander und von anderen durchgehenden elektrisch leitenden Flächen der elektrisch leitenden Lage (3) durch Trennlinien (13) getrennt und dadurch von einander und von anderen durchgehenden elektrisch leitenden Flächen der elektrisch leitenden Lage (3) elektrisch isoliert werden. Von der elektrisch leitenden Lage (1) wird ebenfalls lediglich ein Teil dargestellt, welcher einer durchgehenden elektrisch leitenden Fläche der elektrisch leitenden Lage (1) entspricht, welche von anderen durchgehenden elektrisch leitenden Flächen der elektrisch leitenden Lage (1) durch Trennlinien (in dieser Lage nicht dargestellt) getrennt und dadurch von anderen durchgehenden elektrisch leitenden Flächen der elektrisch leitenden Lage (1) elektrisch isoliert wird. Die Durchbrüche (10) in der elektrisch leitenden Lage (3) sind dabei größer als die Durchbrüche (8,9) in den elektrisch nicht leitenden Lagen (2,4). Dank der an den größeren Durchbrüchen (10) in der elektrisch leitenden Lage (3) freigelegten darunter un/oder darüber liegenden elektrisch nicht leitenden Lage(n) (2,4) kann ein elektrischer Kontakt zwischen der elektrisch leitenden Lage (3) und mindestens einem Lot und/oder mindestens einem elektrisch leitenden Kleber, welches/welcher zum Beispiel insbesondere durch diese Durchbrüche (10) sowie durch die Durchbrüche (8, 9) darunter und/oder darüber beziehungsweise direkt darunter und/oder direkt darüber liegenden elektrisch nicht leitenden Lagen (2,4) zu der jenseits davon (darunter) angeordneten unteren/untersten elektrisch leitenden Lage (1) reichen kann, gegebenenfalls möglichst verhindert werden.

Zudem kann die elektrisch leitende Lage (3) eine weitere zusätzliche elektrisch nicht leitende Lage (nicht dargestellt), wie zum Beispiel insbesondere eine Abdecklackschicht beziehungsweise eine Epoxidharzschicht, aufweisen, die über der elektrisch leitenden Lage (3) beziehungsweise auf der den Solarzellen (5) zugewandten Seite der elektrisch leitenden Lage (3) angeordnet sein kann. Die eine zusätzliche elektrisch nicht leitende Lage (nicht dargestellt) bedeckt die elektrisch leitende Lage (3), wobei Stellen an denen die elektrisch nicht leitenden Lagen (2,4) Durchbrüche (8,9) aufweisen jedoch ausgenommen sind, sodass die Durchbrüche (8,9) der elektrisch nicht leitenden Lage (2,4) nicht bedeckt/verdeckt/verschlossen werden. Dadurch kann ein elektrischer Kontakt zwischen der elektrisch leitenden Lage (3) und mindestens einem Lot und/oder einem elektrisch leitenden Kleber, welcher/welches insbesondere zum Beispiel beim Verbinden beziehungsweise beim unmittelbaren Verbinden der Rückkontakte (6 oder 7) jeder Solarzelle (5) mit der jenseits/unter der/den elektrisch nicht leitenden Lagen (2,4) und der elektrisch leitenden Lage (3) angeordneten weiteren elektrisch leitenden Lage (1) verwendet werden kann, möglichst verhindert werden. In der Tat kann die elektrisch leitenden Lage (1) durch die größeren Durchbrüche (10) in der elektrisch leitenden Lage (3) hindurch insbesondere zum Beispiel durch mindestens ein Lot und/oder mindestens einen elektrisch leitenden Kleber mit den Rückkontakten (6 oder 7) jeder Solarzelle verbunden werden.

Die obere/oberste nicht elektrisch leitende Lage (4) ist sofort unter den Solarzellen (5) angeordnet und kann dabei einer zusätzlichen elektrischen nicht leitenden entsprechen. Die obere/oberste elektrisch leitende Lage (3) ist direkt darunter angeordnet. Die untere/unterste elektrisch nicht leitende Lage (2) ist direkt unter der oberen/obersten elektrisch leitenden Lage (3) angeordnet. Die untere/unterste elektrisch leitende Lage (1) ist wiederum direkt unter der unteren/untersten elektrisch nicht leitenden Lage (2) angeordnet.

Die Durchbrüche (8) der elektrisch nicht leitenden Lage (2) sind dabei an den gleichen Stellen wie beziehungsweise gegenüber die/den Durchbrüche(n) (10) der elektrisch leitenden Lage (3) angeordnet. Dies kann zum Beispiel bedeuten, dass die Position der Durchbrüche (8, 10) in den Lagen (2,3) übereinstimmt. Die zusätzliche elektrisch nicht leitende Lage (4) kann sowohl Durchbrüche (9) aufweisen, die an den gleichen Stellen wie beziehungsweise gegenüber die/den Durchbrüche(n) (10,8) der elektrisch leitenden Lage (3) und der elektrisch nicht leitenden Lage (2) angeordnet sind, als auch Durchbrüche (9) aufweisen, die nicht an den gleichen Stellen wie beziehungsweise gegenüber die/den Durchbrüche(n) (10,8) der elektrisch leitenden Lage (3) und der elektrisch nicht leitenden Lage (2) angeordnet sind. Dadurch können die Rückkontakte (7) einer Solarzelle (5), die zum Beispiel den Pluspol dieser Solarzelle darstellen, durch die Durchbrüche (9) der elektrisch nicht leitenden Lage (4) lediglich mit einer durchgehenden elektrisch leitenden Fläche (12) der elektrisch leitenden Lage (3) verbunden werden. Die Rückkontakte (6) der gleichen Solarzellen (5), die den Minuspol dieser Solarzelle darstellen, können durch die Durchbrüche (9) der elektrisch nicht leitenden Lage (4), die Durchbrüche (10) der elektrisch leitenden Lage (3) und die Durchbrüche (8) der elektrisch nicht leitenden Lage (2) mit einer durchgehenden elektrisch leitenden Fläche der elektrisch leitenden Lage (1) verbunden werden. Zudem können die Rückkontakte (6) einer weiteren benachbarten Solarzelle (5), die den Minuspol dieser Solarzelle darstellen, durch die Durchbrüche (9) der elektrisch nicht leitenden Lage (4) lediglich mit einer weiteren anderen rechteckigen durchgehenden elektrisch leitenden Fläche (11) der elektrisch leitenden Lage (3) verbunden werden. Die Rückkontakte (7) der gleichen Solarzellen (5), die den Pluspol dieser Solarzellen darstellen, können durch die Durchbrüche (9) der elektrisch nicht leitenden Lage (4), die Durchbrüche (10) der elektrisch leitenden Lage (3) und die Durchbrüche (8) der elektrisch nicht leitenden Lage (2) mit der gleichen durchgehenden elektrisch leitenden Fläche der elektrisch leitenden Lage (1) verbunden werden. Die benachbarten Solarzellen können dabei nachgeschaltete und in Serie geschaltete Solarzellen darstellen. Dadurch können die Solarzellen (5) besonders bequem durch eine erfindungsgemäße mehrlagige Rückkontaktfolie über mindestens zwei elektrisch leitende Lagen (1,3) in Serie geschaltet werden. Die rechteckigen durchgehenden elektrisch leitenden Flächen (11,12) der elektrisch leitenden Lage (3) und die dargestellte durchgehende elektrisch leitende Flache der elektrisch leitenden Lage (1) erstrecken sich dabei zumindest teilweise über die von zwei Solarzellen und insbesondere von zwei benachbarten Solarzellen bedeckte Fläche. Die durchgehenden elektrisch leitenden Flächen einer der elektrisch leitenden Lagen (1) erstrecken sich zudem zumindest teilweise unter zwei rechteckige durchgehende elektrisch leitende Flächen (11,12) einer weiteren der elektrisch leitenden Lage (3) beziehungsweise der anderen der elektrisch leitenden Lagen (3). Dadurch können Solarzellen und insbesondere benachbarte Solarzellen mit einer erfindungsgemäßen mehrlagigen Rückkontaktfolie besonders bequem jeweils in Serie geschaltet werden.

Fig. 2 zeigt einen Querschnitt einer Ausführungsform einer erfindungsgemäßen mehrlagigen Rückkontaktfolie. Die obere/oberste zusätzliche nicht elektrisch leitende Lage (4) zum Beispiel aus einer EVA-Folie ist sofort unter den Solarzellen (5) aus Silizium mit Rückkontakten (6,7) und einer Aluminium Rückseite (16) angeordnet, wobei die Vorderkontakte als Metal-Wrap-Through-Kontakte (17) als Rückkontakte (7) zur Rückseite der Solarzelle geführt werden. Die obere/oberste elektrisch leitende Lage (3) zum Beispiel aus Kupfer ist darunter angeordnet. Die untere/unterste elektrisch nicht leitende Lage (2) zum Beispiel aus einer PET-Folie ist direkt unter der oberen/obersten elektrisch leitenden Lage (3) angeordnet. Die untere/unterste elektrisch leitende Lage (1) zum Beispiel aus Kupfer ist wiederum direkt unter der unteren/untersten elektrisch nicht leitenden Lage (2) angeordnet. Die Durchbrüche (10) der elektrisch leitenden Lage (3) sind dabei größer als die Durchbrüche (8,9) der elektrisch nicht leitenden Lage (2,4). Dadurch kann ein elektrischer Kontakt zwischen der elektrisch leitenden Lage (3) und mindestens einem Lot und/oder mindestens einem elektrisch leitenden Kleber, welches/welcher zum Beispiel insbesondere durch die Durchbrüche (10) der elektrisch leitenden Lage (3) sowie durch die Durchbrüche (8, 9) der elektrisch nicht leitenden Lagen (2,4) zu der jenseits davon (darunter) angeordneten unteren/untersten elektrisch leitenden Lage (1) reichen kann, gegebenenfalls möglichst verhindert werden.

Darüber hinaus ist eine weitere zusätzliche elektrisch nicht leitende Lage (15), wie zum Beispiel eine Abdecklackschicht beziehungsweise eine Epoxidharzschicht, direkt über der oberen/obersten elektrisch leitenden Lage (3) der mehrlagigen Rückkontaktefolie angeordnet. Diese zusätzliche elektrisch nicht leitende Lage (15) zum Beispiel aus einer Abdecklackschicht beziehungsweise einer Epoxidharzschicht kann dabei die obere/oberste elektrisch leitende Lage (3) vollkommen bedecken, wobei lediglich die Stellen, an denen die darüber liegende elektrisch nicht leitende Lage (4) zum Beispiel aus einer EVA-Folie Durchbrüche (9) aufweist, ausgenommen sein können. Des Weiteren wird dargestellt, dass die Rückkontakte (7) einer Solarzelle (5) durch Durchbrüche (9) in der oberen/obersten elektrisch nicht leitenden Lage (4) hindurch durch einen elektrisch leitenden Kleber (14) und/oder ein Lot (14) mit der oberen/obersten elektrisch leitenden Lage (3) und insbesondere mit einer durchgehenden elektrisch leitenden Fläche der oberen/obersten elektrisch leitenden Lage (3) verbunden werden. Die Rückkontakte (6) einer Solarzelle (5) werden dabei durch Durchbrüche (9) in der oberen/obersten elektrisch nicht leitenden Lage (4), die größeren Durchbrüche (10) der elektrisch leitenden Lage (3) und die Durchbrüche (8) der elektrisch nicht leitenden Lage (2) hindurch durch einen elektrisch leitenden Kleber (14) und/oder ein Lot (14) mit der elektrisch leitenden Lage (1) und insbesondere mit einer durchgehenden elektrisch leitenden Fläche der elektrisch leitenden Lage (1) verbunden.

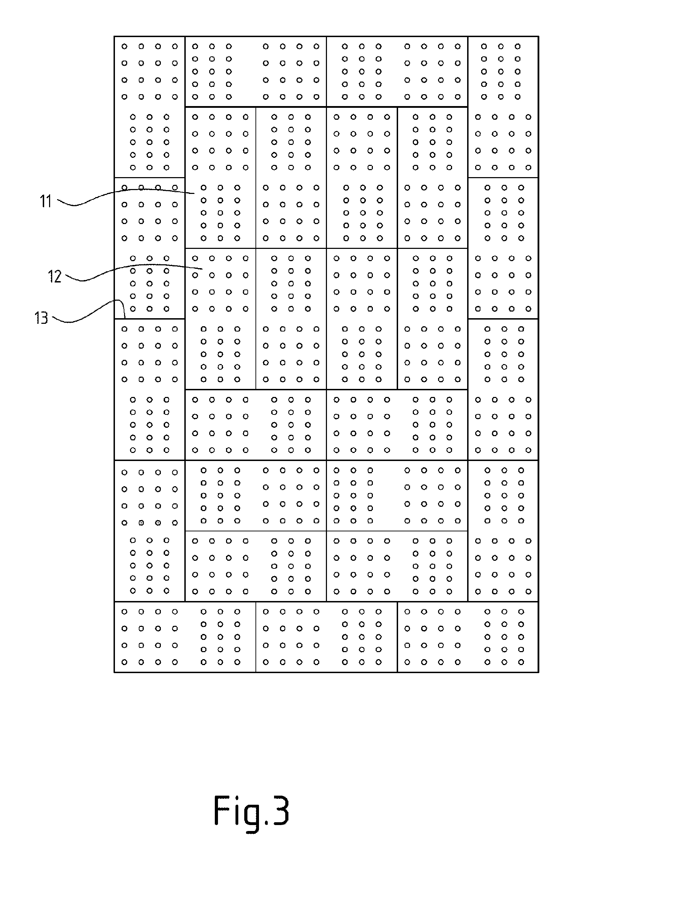

Fig.3 zeigt eine Draufsicht einer oberen/obersten elektrisch leitenden Lage (3), welche Durchbrüche (10) umfassen kann. Zudem ist die Anordnung der durch Trennlinien (13) getrennten rechteckigen durchgehenden elektrisch leitenden Flächen (11,12) der oberen/obersten elektrisch leitenden Lage (3) zu sehen. Die rechteckigen durchgehenden elektrisch leitenden Flächen (11,12) erstrecken sich dabei jeweils zumindest teilweise über die von zwei Solarzellen und insbesondere von zwei benachbarten Solarzellen bedeckte Fläche. Die rechteckigen durchgehenden elektrisch leitenden Flächen (11,12) der elektrisch leitenden Lagen (3) erstecken sich jeweils zumindest teilweise über zwei rechteckige durchgehende elektrisch leitende Flächen (21,22) der anderen elektrisch leitenden Lage (1). Die dargestellte Anordnung kann es gegebenenfalls ermöglichen drei Solarzellstrings vorzusehen, welche jeweils mehrere über die zwei elektrisch leitenden Lagen in Serie geschaltete benachbarte Solarzellen umfassen und durch jeweils mindestens eine vorgesehene Bypass-Diode im Stromkreis gegebenenfalls umgangen werden können.

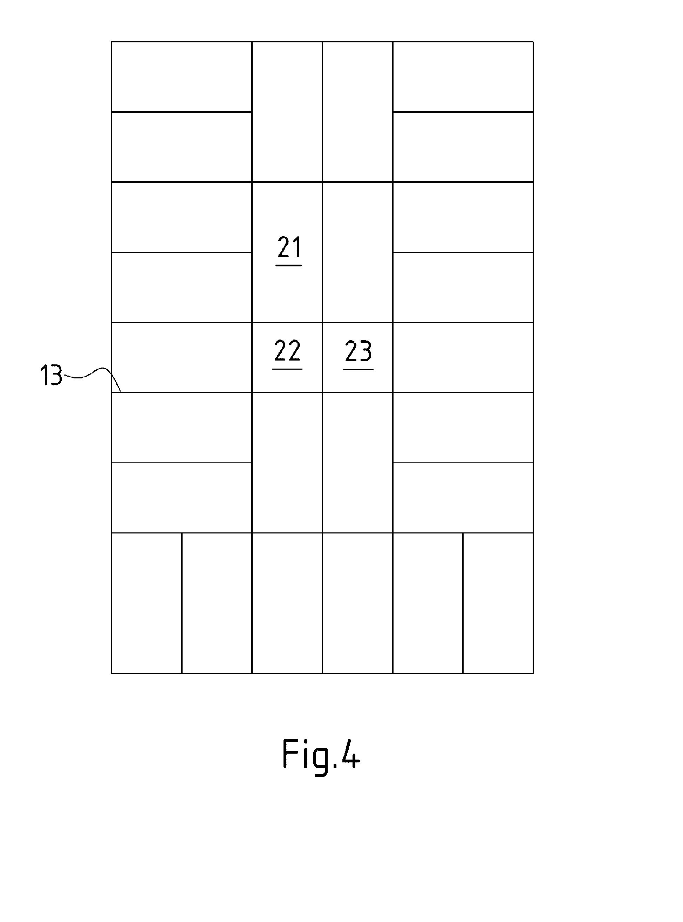

Fig.4 zeigt eine Draufsicht einer unteren/untersten elektrisch leitenden Lage (1), welche keine Durchbrüche umfasst. Zudem ist die Anordnung der durch Trennlinien (13) getrennten rechteckigen durchgehenden elektrisch leitenden Flächen (21) der unteren/untersten elektrisch leitenden Lage (1) zu sehen. Die rechteckigen durchgehenden elektrisch leitenden Flächen (21) erstrecken sich dabei jeweils zumindest teilweise über die von zwei Solarzellen und insbesondere von zwei benachbarten Solarzellen bedeckte Fläche. Es werden jedoch auch zwei am Anschlusspunkt vorgesehene beziehungsweise zumindest teilweise unter der Anschlussbuchse angeordnete quadratische durchgehende elektrisch leitende Flächen (22,23), die den Pluspol und den Minuspol eines Modul darstellen können und deren Größe in etwa der Größe einer Solarzelle entsprechen kann, gezeigt. Die rechteckigen elektrisch leitenden durchgehenden Flächen (21) der elektrisch leitenden Lagen (1) erstecken sich jeweils zumindest teilweise unter zwei rechteckige durchgehende elektrisch leitende Flächen (11, 12) der anderen elektrisch leitenden Lage (3). Die dargestellte Anordnung kann es gegebenenfalls ermöglichen drei Solarzellstrings vorzusehen, welche jeweils mehrere über die zwei elektrisch leitenden Lagen in Serie geschaltete benachbarte Solarzellen umfassen und durch jeweils mindestens eine vorgesehene Bypass-Diode im Stromkreis gegebenenfalls umgangen werden können.

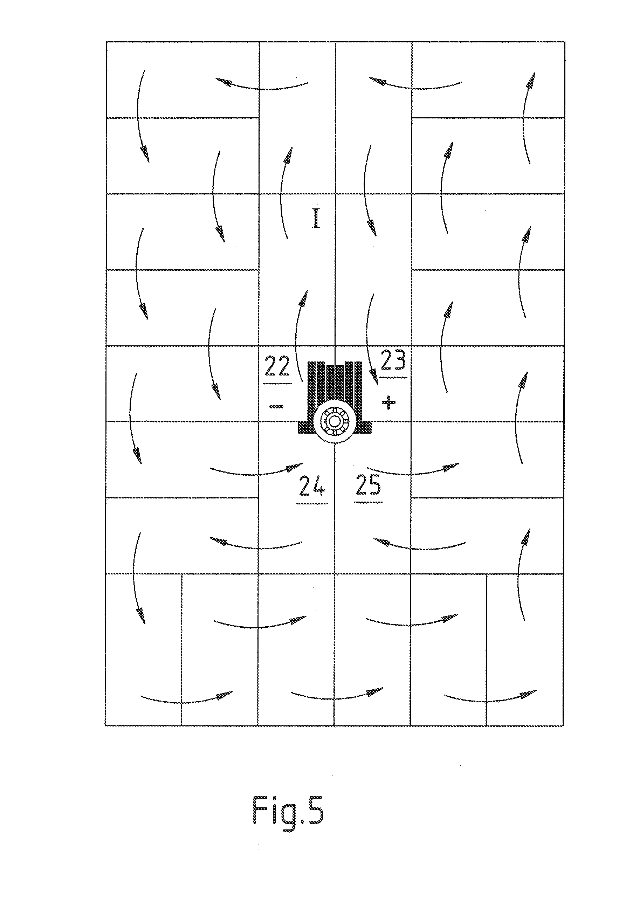

Fig. 5 stellt den Fluss des elektrischen Stroms in der unteren/untersten elektrisch leitenden Lage (1) bei der Verwendung einer mehrlagigen Rückkontaktfolie mit der in den Figuren 1, 2 und 3 beschriebenen Gestaltung anhand von Pfeilen schematisch dar. Zudem sind die zwei in der unteren/untersten elektrisch leitenden Lage (1) vorgesehenen quadratischen durchgehenden elektrisch leitenden Flächen (22,23) jeweils als Pluspol und als Minuspol des Moduls und/oder jedes Solarzellstrings gekennzeichnet. Des Weiteren sind die am Anschlusspunkt vorgesehenen Kontakte und die Anschlussbuchse dargestellt.

Für jeden Solarzellstring kann dabei jeweils mit einem Pluspol und einem Minuspol an den Anschlusspunkt geführt werden und gegebenenfalls mit mindestens einem am Anschlusspunkt vorgesehenen Kontakt verbunden werden. Alle Solarzellen (5), die mit der in den Figuren 1, 2, 3, 4 und 5 dargestellten mehrlagigen Rückkontaktfolie verbunden werden, werden über die beiden elektrisch leitenden Lagen (1,3) in Serie geschaltet. Die am Anschlusspunkt vorgesehen Kontakte sind dabei mit der Anschlussbuchse verbunden. Ein Solarzellstring kann dabei zum Beispiel an der quadratischen durchgehenden elektrisch leitenden Fläche (22) beginnen und an der Hälfte durchgehenden elektrisch leitenden Fläche (24), die an der Anschlussbuchse angrenzt, enden. Ein zweiter Solarzellstring kann zum Beispiel an der Hälfte durchgehenden elektrisch leitenden Fläche (25), die an der Anschlussbuchse angrenzt, beginnen und an der quadratischen durchgehenden elektrisch leitenden Fläche (23) enden. Ein dritter Solarzellstring kann alle übrigen Solarzellen umfassen, wobei dieser String an der Hälfte durchgehenden elektrisch leitenden Fläche (24), die von der Anschlussbuchse weiter entfernt ist, beginnen kann und an der Hälfte durchgehenden elektrisch leitenden Fläche (25), die von der Anschlussbuchse weiter entfernt ist, enden kann. Die quadratischen durchgehenden elektrisch leitenden Flächen (22, 23) können dabei mit jeweils drei am Anschlusspunkt vorgesehenen Kontakten verbunden sein beziehungsweise über diese Kontakte mit der Anschlussbuchse verbunden sein. Die Punkte (24, 25) sind jeweils mit einem am Anschlusspunkt vorgesehenen Kontakt verbunden beziehungsweise jeweils über diesen Kontakt mit der Anschlussbuchse verbunden. Dabei können durch die Gestaltung der elektrisch leitenden Lage (1,3) gemäß den Figuren 1, 2, 3 und 4 bevorzugt drei Solarzellstrings mit 18 in Serie geschalteten Solarzellen, wobei mindestens ein Teil der Solarzellen jedes Solarzellstrings jeweils über mindestens eine Bypass-Diode und insbesondere über mindestens einer bevorzugt zum Beispiel in der Anschlussbuchse vorgesehenen Bypass-Diode und/oder den am Anschlusspunkt vorgesehenen Kontakten im Stromkreis umgangen werden können, vorgesehen sein. Dadurch können gegebenenfalls dreimal je 18 in Serie geschaltete Solarzellen gegebenenfalls über jeweils mindestens eine Bypass-Diode und insbesondere über mindestens einer bevorzugt zum Beispiel in der Anschlussbuchse vorgesehenen Bypass-Diode und/oder den am Anschlusspunkt vorgesehenen Kontakten im Stromkreis umgangen werden.

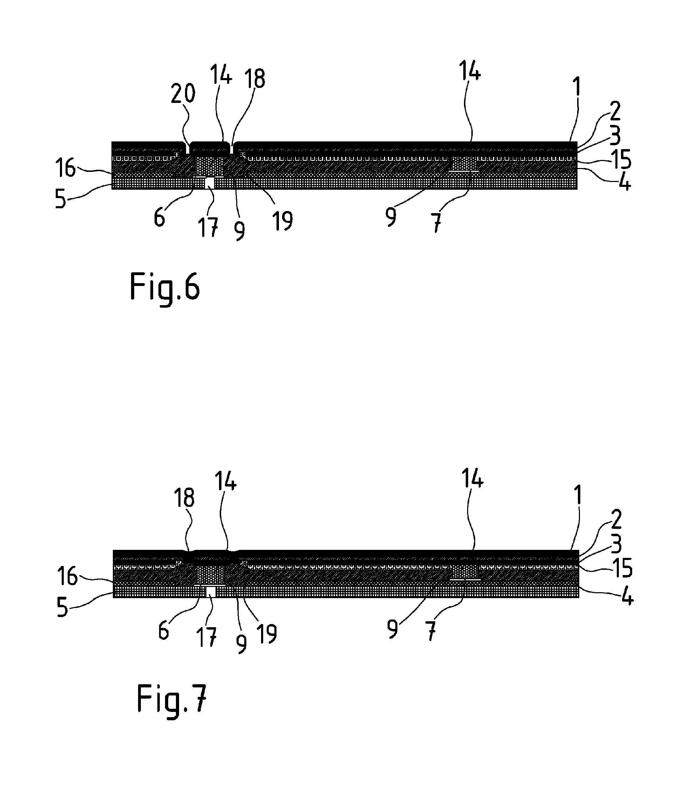

Fig. 6 zeigt einen Querschnitt einer weiteren Ausführungsform einer erfindungsgemäßen mehrlagigen Rückkontaktfolie. Die obere/oberste nicht elektrisch leitende Lage (4) zum Beispiel aus einer EVA-Folie ist sofort unter den Solarzellen (5) aus Silizium mit Rückkontakten (6,7) und einer Aluminium Rückseite (16) angeordnet, wobei die Vorderkontakte als Metal-Wrap-Through-Kontakte (17) als Rückkontakte (7) zur Rückseite der Solarzelle geführt werden. Die obere/oberste elektrisch leitende Lage (3) zum Beispiel aus Kupfer ist darunter angeordnet. Die untere/unterste elektrisch nicht leitende Lage (2) zum Beispiel aus einer PET-Folie ist direkt unter der oberen/obersten elektrisch leitenden Lage (3) angeordnet. Die untere/unterste elektrisch leitende Lage (1) zum Beispiel aus Kupfer ist wiederum direkt unter der unteren/untersten elektrisch nicht leitenden Lage (2) angeordnet. Darüber hinaus ist eine zusätzliche elektrisch nicht leitende Lage (15) zum Beispiel aus einer Abdecklackschicht beziehungsweise einer Epoxidharzschicht direkt über der oberen/obersten elektrisch leitenden Lage (3) der mehrlagigen Rückkontaktefolie angeordnet. Diese zusätzliche elektrisch nicht leitende Lage (15) zum Beispiel aus einer Abdecklackschicht beziehungsweise einer Epoxidharzschicht kann dabei die obere/oberste elektrisch leitende Lage (3) vollkommen bedecken, wobei lediglich die Stellen, an denen die darüber liegende elektrisch nicht leitende Lage (4) zum Beispiel aus einer EVA-Folie Durchbrüche (9) aufweist, ausgenommen sein können. Des Weiteren wird dargestellt, dass die Rückkontakte (7) einer Solarzelle (5) durch Durchbrüche (9) in der oberen/obersten elektrisch nicht leitenden Lage (4) hindurch durch einen elektrisch leitenden Kleber (14) und/oder ein Lot (14) mit der oberen/obersten elektrisch leitenden Lage (3) und insbesondere mit einer durchgehenden elektrisch leitenden Fläche der oberen/obersten elektrisch leitenden Lage (3) verbunden werden. Die Rückkontakte (6) einer Solarzelle (5) werden dabei durch Durchbrüche (9) in der oberen/obersten elektrisch nicht leitenden Lage (4), zunächst durch einen elektrisch leitenden Kleber (14) und/oder ein Lot (14) mit einem Teil der oberen/obersten elektrisch leitenden Lage (3) verbunden, welcher durch eine ringförmige Aussparung (19) vom Rest dieser elektrisch leitenden Lage (3) elektrisch isoliert ist. Dabei sind innerhalb des Teils der oberen/obersten elektrisch leitenden Lage (3), welcher durch eine ringförmige Aussparung (19) vom Rest dieser elektrisch leitenden Lage (3) elektrisch isoliert ist, Durchbrüche (18) in der oberen/obersten elektrisch leitenden Lage (3), in der elektrisch nicht leitenden Lage (2) und in der unteren/untersten elektrisch leitenden Lage (1) vorgesehen. Ein elektrischer Kontakt zwischen dem Teil der oberen/obersten elektrisch leitenden Lage (3), welcher durch eine ringförmige Aussparung (19) vom Rest dieser elektrisch leitenden Lage (3) elektrisch isoliert ist, und der elektrisch leitenden Lage (1) und insbesondere mit einer durchgehenden elektrisch leitenden Fläche der elektrisch leitenden Lage (1) kann dabei durch auf den Seitenwänden der Durchbrüche (18) abgeschiedenes elektrisch leitendes Material (20) hergestellt werden.

Fig. 7 zeigt einen Querschnitt einer weiteren Ausführungsform einer erfindungsgemäßen mehrlagigen Rückkontaktfolie. Die obere/oberste nicht elektrisch leitende Lage (4) zum Beispiel aus einer EVA-Folie ist sofort unter den Solarzellen (5) aus Silizium mit Rückkontakten (6,7) und einer Aluminium Rückseite (16) angeordnet. Wobei die Vorderkontakte als Metal-Wrap-Through-Kontakte (17) als Rückkontakte (7) zur Rückseite der Solarzelle geführt werden. Die obere/oberste elektrisch leitende Lage (3) zum Beispiel aus Kupfer ist darunter angeordnet. Die untere/unterste elektrisch nicht leitende Lage (2) zum Beispiel aus einer PET-Folie ist direkt unter der oberen/obersten elektrisch leitenden Lage (3) angeordnet. Die untere/unterste elektrisch leitende Lage (1) zum Beispiel aus Kupfer ist wiederum direkt unter der unteren/untersten elektrisch nicht leitenden Lage (2) angeordnet. Darüber hinaus ist eine zusätzliche elektrisch nicht leitende Lage (15) zum Beispiel aus einer Abdecklackschicht beziehungsweise einer Epoxidharzschicht direkt über der oberen/obersten elektrisch leitenden Lage (3) der mehrlagigen Rückkontaktefolie angeordnet. Diese zusätzliche elektrisch nicht leitende Lage (15) zum Beispiel aus einer Abdecklackschicht beziehungsweise einer Epoxidharzschicht bedeckt dabei die obere/oberste elektrisch leitende Lage (3) vollkommen bedecken, wobei lediglich die Stellen, an denen die darüber liegende elektrisch nicht leitende Lage (4) zum Beispiel aus einer EVA-Folie Durchbrüche (9) aufweist, ausgenommen sein können. Des Weiteren wird dargestellt, dass die Rückkontakte (7) einer Solarzelle (5) durch Durchbrüche (9) in der oberen/obersten elektrisch nicht leitenden Lage (4) hindurch durch einen elektrisch leitenden Kleber (14) und/oder ein Lot (14) mit der oberen/obersten elektrisch leitenden Lage (3) und insbesondere mit einer durchgehenden elektrisch leitenden Fläche der oberen/obersten elektrisch leitenden Lage (3) verbunden werden. Die Rückkontakte (6) einer Solarzelle (5) werden dabei durch Durchbrüche (9) in der oberen/obersten elektrisch nicht leitenden Lage (4), zunächst durch einen elektrisch leitenden Kleber (14) und/oder ein Lot (14) mit einem Teil der oberen/obersten elektrisch leitenden Lage (3) verbunden, welcher durch eine ringförmige Aussparung (19) vom Rest dieser elektrisch leitenden Lage (3) elektrisch isoliert ist. Dabei sind innerhalb des Teils der oberen/obersten elektrisch leitenden Lage (3), welcher durch eine ringförmige Aussparung (19) vom Rest dieser elektrisch leitenden Lage (3) elektrisch isoliert ist, Durchbrüche (18) in der oberen/obersten elektrisch leitenden Lage (3), in der elektrisch nicht leitenden Lage (2) und in der unteren/untersten elektrisch leitenden Lage (1) vorgesehen. Ein elektrischer Kontakt zwischen dem Teil der oberen/obersten elektrisch leitenden Lage (3), welcher durch eine ringförmige Aussparung (19) vom Rest dieser elektrisch leitenden Lage (3) elektrisch isoliert ist, und der elektrisch leitenden Lage (1) und insbesondere mit einer durchgehenden elektrisch leitenden Fläche der elektrisch leitenden Lage (1) kann dabei durch auf den Seitenwänden der Durchbrüche (18) abgeschiedenes elektrisch leitendes Material (20) hergestellt werden, wobei die Durchbrüche (18) durch das abgeschiedene elektrisch leitende Material gegeben falls ganz gefüllt werden.

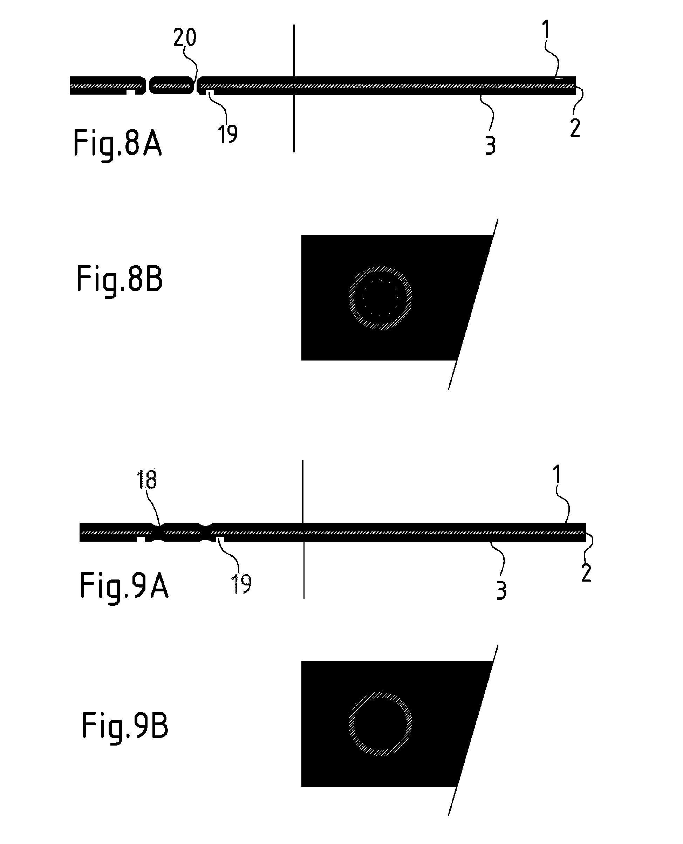

Fig. 8A zeigt einen Querschnitt der Lagen 1, 2 und 3 einer weiteren Ausführungsform einer erfindungsgemäßen mehrlagigen Rückkontaktfolie, wobei die Lagen 1, 2 und 3 ähnlich zu der in Fig.6 dargestellten Ausführungsform ausgestaltet sind. Die elektrisch nicht leitende Lage (2) zum Beispiel aus einer PET-Folie ist direkt unter der oberen/obersten elektrisch leitenden Lage (3) angeordnet. Die untere/unterste elektrisch leitende Lage (1) zum Beispiel aus Kupfer ist wiederum direkt unter der unteren/untersten elektrisch nicht leitenden Lage (2) angeordnet. Zudem kann die mehrlagige Rückkontaktfolie noch eine zusätzliche elektrisch nicht leitende Lage (4, nicht dargestellt) zum Beispiel aus einer EVA-Folie mit Durchbrüchen (9, nicht dargestellt) umfassen, die darüber angeordnet werden kann. Darüber hinaus kann eine weitere zusätzliche elektrisch nicht leitende Lage (15, nicht dargestellt) zum Beispiel aus einer Abdecklackschicht beziehungsweise einer Epoxidharzschicht direkt über der oberen/obersten elektrisch leitenden Lage (3) der mehrlagigen Rückkontaktefolie angeordnet. Diese weitere zusätzliche elektrisch nicht leitende Lage (15, nicht dargestellt) zum Beispiel aus einer Abdecklackschicht beziehungsweise einer Epoxidharzschicht kann dabei die obere/oberste elektrisch leitende Lage (3) vollkommen bedecken, wobei lediglich die Stellen, an denen die darüber liegende elektrisch nicht leitende Lage (4, nicht dargestellt) zum Beispiel aus einer EVA-Folie Durchbrüche (9, nicht dargestellt) aufweist, ausgenommen sein können. Darüber hinaus wird dargestellt, dass ein Teil der oberen/obersten elektrisch leitenden Lage (3) durch eine ringförmige Aussparung (19) vom Rest dieser elektrisch leitenden Lage (3) elektrisch isoliert ist. Dabei sind innerhalb des Teils der oberen/obersten elektrisch leitenden Lage (3), welcher durch eine ringförmige Aussparung (19) vom Rest dieser elektrisch leitenden Lage (3) elektrisch isoliert ist, Durchbrüche (18) in der oberen/obersten elektrisch leitenden Lage (3), in der elektrisch nicht leitenden Lage (2) und in der unteren/untersten elektrisch leitenden Lage (1) vorgesehen. Ein elektrischer Kontakt zwischen dem Teil der oberen/obersten elektrisch leitenden Lage (3), welcher durch eine ringförmige Aussparung (19) vom Rest dieser elektrisch leitenden Lage (3) elektrisch isoliert ist, und der elektrisch leitenden Lage (1) und insbesondere mit einer durchgehenden elektrisch leitenden Fläche der elektrisch leitenden Lage (1) kann dabei durch auf den Seitenwänden der Durchbrüche (18) abgeschiedenes elektrisch leitendes Material (20) hergestellt werden. Die elektrische Verbindung mit den Solarzellen kann dabei wie in der Fig. 6 dargestellt erfolgen.

Fig. 8B zeigt eine Draufsicht auf die elektrisch leitende Lage (3) der in Fig. 8A dargestellten Ausführungsform einer erfindungsgemäßen mehrlagigen Rückkontaktfolie. Dabei wird die elektrisch leitende Lage (3) mit einer ringförmigen Aussparung (18) und der durch die Aussparung freigelegten direkt darunter liegenden elektrisch nicht leitenden Lage (2) gezeigt. Des Weiteren werden auch die in dem Teil der oberen/obersten elektrisch leitenden Lage (3), welcher durch eine ringförmige Aussparung (19) vom Rest dieser elektrisch leitenden Lage (3) elektrisch isoliert ist, vorgesehenen Durchbrüche (18) in der oberen/obersten elektrisch leitenden Lage (3), in der elektrisch nicht leitenden Lage (2) und in der unteren/untersten elektrisch leitenden Lage (1) dargestellt.

Fig. 9A zeigt einen Querschnitt der Lagen 1, 2 und 3 einer weiteren Ausführungsform einer erfindungsgemäßen mehrlagigen Rückkontaktfolie, wobei die Lagen 1, 2 und 3 ähnlich zu der in Fig.7 dargestellten Ausführungsform ausgestaltet sind. Die elektrisch nicht leitende Lage (2) zum Beispiel aus einer PET-Folie ist direkt unter der oberen/obersten elektrisch leitenden Lage (3) angeordnet. Die untere/unterste elektrisch leitende Lage (1) zum Beispiel aus Kupfer ist wiederum direkt unter der unteren/untersten elektrisch nicht leitenden Lage (2) angeordnet. Zudem kann die mehrlagige Rückkontaktfolie noch eine zusätzliche elektrisch nicht leitende Lage (4, nicht dargestellt) zum Beispiel aus einer EVA-Folie mit Durchbrüchen (9, nicht dargestellt) umfassen, die darüber angeordnet sein kann. Darüber hinaus kann eine weitere zusätzliche elektrisch nicht leitende Lage (15, nicht dargestellt) zum Beispiel aus einer Abdecklackschicht beziehungsweise einer Epoxidharzschicht direkt über der oberen/obersten elektrisch leitenden Lage (3) der mehrlagigen Rückkontaktefolie angeordnet. Diese weitere zusätzliche elektrisch nicht leitende Lage (15, nicht dargestellt) zum Beispiel aus einer Abdecklackschicht beziehungsweise einer Epoxidharzschicht kann dabei die obere/oberste elektrisch leitende Lage (3) vollkommen bedecken, wobei lediglich die Stellen, an denen die darüber liegende elektrisch nicht leitende Lage (4, nicht dargestellt) zum Beispiel aus einer EVA-Folie Durchbrüche (9, nicht dargestellt) aufweist, ausgenommen sein können. Darüber hinaus wird dargestellt, dass ein Teil der oberen/obersten elektrisch leitenden Lage (3) durch eine ringförmige Aussparung (19) vom Rest dieser elektrisch leitenden Lage (3) elektrisch isoliert ist. Dabei sind innerhalb des Teils der oberen/obersten elektrisch leitenden Lage (3), welcher durch eine ringförmige Aussparung (19) vom Rest dieser elektrisch leitenden Lage (3) elektrisch isoliert ist, Durchbrüche (18) in der oberen/obersten elektrisch leitenden Lage (3), in der elektrisch nicht leitenden Lage (2) und in der unteren/untersten elektrisch leitenden Lage (1) vorgesehen. Ein elektrischer Kontakt zwischen dem Teil der oberen/obersten elektrisch leitenden Lage (3), welcher durch eine ringförmige Aussparung (19) vom Rest dieser elektrisch leitenden Lage (3) elektrisch isoliert ist, und der elektrisch leitenden Lage (1) und insbesondere mit einer durchgehenden elektrisch leitenden Fläche der elektrisch leitenden Lage (1) kann dabei durch auf den Seitenwänden der Durchbrüche (18) abgeschiedenes elektrisch leitendes Material (20) hergestellt werden, wobei die Durchbrüche (18) durch das abgeschiedene elektrisch leitende Material gegebenenfalls ganz gefüllt werden. Die elektrische Verbindung mit den Solarzellen kann dabei wie in der Fig. 7 dargestellt erfolgen.

Fig. 9B zeigt eine Draufsicht auf die elektrisch leitende Lage (3) der in Fig. 9A dargestellten Ausführungsform einer erfindungsgemäßen mehrlagigen Rückkontaktfolie. Dabei wird die elektrisch leitende Lage (3) mit einer ringförmigen Aussparung (18) und der durch die Aussparung freigelegten direkt darunter liegenden elektrisch nicht leitenden Lage (2) gezeigt. Des Weiteren werden auch die in dem Teil der oberen/obersten elektrisch leitenden Lage (3), welcher durch eine ringförmige Aussparung (19) vom Rest dieser elektrisch leitenden Lage (3) elektrisch isoliert ist, dargestellt. Die vorgesehenen Durchbrüche (18) in der oberen/obersten elektrisch leitenden Lage (3), in der elektrisch nicht leitenden Lage (2) und in der unteren/untersten elektrisch leitenden Lage (1) sind ganz durch elektrisch leitendes Material gefüllt und können somit nicht mehr von der elektrisch leitenden Lage (3) unterschieden werden.

## Patentansprüche

1. Mehrlagige Rückkontaktfolie zum Verbinden von Solarzellen,
**dadurch gekennzeichnet,**
**dass** sie mindestens zwei elektrisch leitende Lagen sowie eine dazwischen angeordnete elektrisch nicht leitende Lage umfasst.

2. Mehrlagige Rückkontaktfolie zum Verbinden von Solarzellen nach Anspruch 1,
**dadurch gekennzeichnet,**
**dass** ein einziger Anschlusspunkt vorgesehen ist.

3. Mehrlagige Rückkontaktfolie zum Verbinden von Solarzellen einem oder beiden der Ansprüche 1 und 2,
**dadurch gekennzeichnet,**
**dass** mindestens eine beziehungsweise mindestens zwei Lage(n) Durchbrüche aufweist/aufweisen und/oder mindestens zwei Lagen dabei zum Beispiel Unterschiede bezüglich der Anzahl und/oder der Anordnung und/oder der Größe der Durchbrüche aufweisen.

4. Mehrlagige Rückkontaktfolie zum Verbinden von Solarzellen nach einem oder mehreren der vorangegangenen Ansprüche,
**dadurch gekennzeichnet,**
**dass** mindestens eine elektrisch leitende Lage mindestens ein Metall und/oder mindestens eine elektrisch nicht leitende Lage mindestens ein Polymer umfasst.

5. Mehrlagige Rückkontaktfolie zum Verbinden von Solarzellen nach einem oder mehreren der vorangegangenen Ansprüche,
**dadurch gekennzeichnet,**
**dass** mindestens eine elektrisch leitende Lage durch Trennbereiche getrennte durchgehende elektrisch leitende Flächen umfasst.

6. Mehrlagige Rückkontaktfolie zum Verbinden von Solarzellen nach einem oder mehreren der vorangegangenen Ansprüche,
**dadurch gekennzeichnet,**
**dass** die mehrlagige Rückkontaktfolie mindestens eine und/oder bevorzugt mindestens zwei und/oder drei zusätzliche elektrisch nicht leitende Lage(n) umfassen.

7. Mehrlagige Rückkontaktfolie zum Verbinden von Solarzellen nach einem oder mehreren der vorangegangenen Ansprüche,
**dadurch gekennzeichnet,**
**dass** die mehrlagige Rückkontaktfolie ein eigenständiges Teil darstellt.

8. Mehrlagige Rückkontaktfolie zum Verbinden von Solarzellen nach einem oder mehreren der vorangegangenen Ansprüche,
**dadurch gekennzeichnet,**
**dass** die mehrlagige Rückkontaktfolie von unten nach oben eine zusätzliche elektrisch nicht leitende Lage, eine elektrisch leitende Lage, eine elektrisch nicht leitende Lage mit Durchbrüchen, eine elektrisch leitende Lage mit Durchbrüchen, eine weitere zusätzliche elektrisch nicht leitende Lage aus einer Abdecklackschicht beziehungsweise einer Epoxidharzschicht und eine weitere zusätzliche elektrisch nicht leitende Lage mit Durchbrüchen umfasst, wobei die obere/oberste zusätzliche elektrisch nicht leitende Lage zum Beispiel mehr Durchbrüche als die darunter liegenden Lagen aufweist und insbesondere zum Beispiel sowohl Durchbrüche aufweist, die nicht gegenüber den Durchbrüchen der direkt darunter liegenden elektrisch leitenden Lage angeordnet sind, als auch Durchbrüche aufweist, die gegenüber den Durchbrüchen der direkt darunter liegenden elektrisch leitenden Lage angeordnet sind, und wobei ferner die obere/oberste elektrisch leitende Lage im Vergleich zu einer direkt darunter liegenden elektrisch nicht leitenden Lage zum Beispiel die gleiche Anzahl an Durchbrüchen aufweist, wobei ferner die Durchbrüche der oberen/obersten elektrisch leitenden Lage zum Beispiel größer sind als die Durchbrüche der darüber und darunter liegenden elektrisch nicht leitenden Lagen mit Durchbrüchen, und diese Durchbrüche zudem zum Beispiel sowohl gegenüber mindestens einem Teil der Durchbrüche, der direkt darüber liegenden elektrisch nicht leitenden Lage als auch gegenüber mindestens einem Teil der Durchbrüche der darunter liegenden elektrisch nicht leitenden Lage angeordnet sind, wobei die unterste elektrisch leitende Lage zwei quadratische durchgehende elektrisch leitende Flächen umfasst, deren Größe ungefähr der Größe einer verwendeten Solarzelle entspricht, wobei ferner die übrigen durchgehenden elektrisch leitenden Flächen der beiden elektrisch leitenden Lagen rechteckig sind und sich bevorzugt zumindest teilweise über die von zwei Solarzellen bedeckte Fläche erstrecken, wobei ferner die durchgehenden elektrisch leitenden Flächen, die sich bevorzugt zumindest teilweise über die von zwei Solarzellen bedeckte Fläche erstrecken und die zu einer elektrisch leitenden Lage gehören, sich zudem zumindest teilweise unter und/oder über zwei durchgehende elektrisch leitende Flächen der jeweils anderen elektrisch leitenden Lage erstrecken.

9. Verfahren zum Verbinden von Solarzellen,
**dadurch gekennzeichnet,**
**dass** eine mehrlagige Rückkontaktfolie nach einem oder mehreren der Ansprüche 1 bis 9 zum Verbinden von Solarzellen verwendet wird.

10. Verfahren zum Verbinden von Solarzellen nach Anspruch 9
**dadurch gekennzeichnet,**
**dass** mindestens zwei elektrisch leitende Lagen einer mehrlagigen Rückkontaktfolie jeweils unmittelbar mit mindestens einem Teil der Rückkontakte jeder Solarzelle verbunden werden.

11. Verfahren zum Verbinden von Solarzellen nach einem oder mehreren der Ansprüche 9 und 10,
**dadurch gekennzeichnet,**
**dass** die Rückkontakte, die den Pluspol oder den Minuspol einer Solarzelle darstellen, respektive jeweils mit einer ersten/oberen/obersten elektrisch leitenden Lage und einer zweiten/unteren/untersten elektrisch leitenden Lage verbunden werden, wobei ferner die Rückkontakte, die den Pluspol oder den Minuspol mindestens einer weiteren Solarzelle darstellen, welche mindestens mit der ersten Solarzelle in Serie geschaltet wird, respektive mit der zweiten/unteren/untersten elektrisch leitenden Lage und der ersten/oberen/obersten elektrisch leitenden Lage verbunden werden.

12. Verfahren zum Verbinden von Solarzellen nach einem oder mehreren der Ansprüche 9 bis 11,
**dadurch gekennzeichnet,**
**dass** für jede Solarzelle jeweils eine elektrisch leitende Lage mit den Rückkontakten, die den Pluspol einer Solarzelle darstellen, und mindestens eine weitere elektrisch leitende Lage mit den Rückkontakten, die den Minuspol der Solarzelle darstellen, verbunden werden.

13. Verfahren zum Verbinden von Solarzellen nach einem oder mehreren der Ansprüche 9 bis 12,
**dadurch gekennzeichnet,**
**dass** mindestens eine Gruppe von mindestens zwei Solarzellen über mindestens zwei elektrisch leitende Lagen einer mehrlagigen Rückkontaktfolie in Serie geschaltet wird.

14. Verfahren zum Verbinden von Solarzellen nach einem oder mehreren der Ansprüche 9 bis 13,
**dadurch gekennzeichnet,**
**dass** mindestens eine und bevorzugt mindestens zwei Gruppen von in Serie geschalteten Solarzellen über mindestens zwei elektrisch leitende Lagen einer mehrlagigen Rückkontaktfolie mit einem Anschlusspunkt verbunden sind.

15. Solarmodul welches eine mehrlagige Rückkontaktfolie nach einem der Ansprüche 1 bis 9 umfasst und/oder unter Verwendung eines Verfahrens nach einem der Ansprüche 9 bis 14 hergestellt wird.
